## Europäisches Patentamt
## European Patent Office
## Office européen des brevets

(11) Veröffentlichungsnummer : **0 400 179 B1**

# (12) EUROPÄISCHE PATENTSCHRIFT

(45) Veröffentlichungstag der Patentschrift :
**19.07.95 Patentblatt 95/29**

(51) Int. Cl.⁶ : **G11C 29/00**

(21) Anmeldenummer : **89109839.4**

(22) Anmeldetag : **31.05.89**

(54) **Verfahren und Vorrichtung zum internen Paralleltest von Halbleiterspeichern.**

(43) Veröffentlichungstag der Anmeldung :
**05.12.90 Patentblatt 90/49**

(45) Bekanntmachung des Hinweises auf die
Patenterteilung :
**19.07.95 Patentblatt 95/29**

(84) Benannte Vertragsstaaten :
**AT DE FR GB IT NL**

(56) Entgegenhaltungen :
**EP-A- 0 263 470**
**US-A- 4 672 582**

(56) Entgegenhaltungen :
**IBM TECHNICAL DISCLOSURE BULLETIN
Band 28, Nr.12, Mai 1986, Seiten 5170, 5171,
New York, USA; Two-pass stuck-fault memory
test error correction code"
IBM TECHNICAL DISCLOSURE BULLETIN
Band 28, Nr. 8, Januar 1986, Seiten 3698, 3699,
NEW YORK, USA; "Memory error detecting
using error correction code hardware"
IBM TECHNICAL DISCLOSURE BULLETIN
Band 24, Nr.1B, Juni 1981, Seiten613,614, New
York, Usa; T.A.FORNOF: Two-pass array test
method"**

(73) Patentinhaber : **SIEMENS
AKTIENGESELLSCHAFT
Wittelsbacherplatz 2
D-80333 München (DE)**

(72) Erfinder : **Mattes, Heinz, Dr., Dipl.-Ing.
Kidlerplatz 8
D-8000 München (DE)**

## Beschreibung

Die Erfindung betrifft ein Verfahren zum Paralleltest von Speicherzellen eines Speichers gemäß dem Oberbegriff des Patentanspruches 1 und eine zugehörige Vorrichtung gemäß dem Oberbegriff des Patentanspruches 6.

Bei der Herstellung von Halbleiterspeichern stellt die Testzeit, in der der gesamte Halbleiterspeicher auf seine Funktionsfähigkeit geprüft werden soll einen wesentlichen Kostenfaktor dar. Insbesondere mit zunehmender Größe der Speicherbausteine nimmt auch die Testzeit in bedeutendem Maße zu.

Mit dem Nachteil einer besonders langen Testzeit wurden bisher fast ausschließlich sequentielle Testverfahren zur Funktionsfähigkeitsprüfung der Halbleiterspeicher eingesetzt. Daher ist man bestrebt, sequentiell durchgeführte Tests so weit wie möglich zu parallelisieren. Hierzu ist aus der Veröffentlichung JEDEC Solid State Products Engineering Council, März 1987 ein Verfahren bzw. eine Vorrichtung für einen Paralleltest bekannt, mit dem es möglich ist, jeweils 4 Bit eines Halbleiterspeichers parallel auszutesten. Für ein solches 4 Bit Parallelverfahren stehen zwei Testmuster zur Verfügung, die in die Speicherzellen parallel eingelesen werden. Ein erstes Testmuster wird hierfür aus einer Einsfolge und ein zweites Testmuster aus einer Nullfolge gebildet. Eine Flexibilität bei der Auswahl möglicher Testmuster bei diesem Verfahren ist nicht gegeben. Außerdem ist bei dem Auslesen des Ergebnisses aus den Speicherzellen nur eine Entscheidung möglich, nämlich ob Fehler in den Speicherzellen vorliegen oder ob alle Speicherzellen funktionsfähig sind.

Aus der europäischen Patentanmeldung mit der Veröffentlichungsnummer 0 263 470 ist ein Verfahren und eine Anordnung zum Testen von MEGA-Bit-Speicherbausteinen mit beliebigen Testbitmustern bekannt, wobei diese beliebigen Testmuster in eine Zellengruppe im Multi-Bit-Testmodus über Testwortregister eingeschrieben und die ausgelesenen Daten mit dem Inhalt der Testwortregister mittels einer Vergleichslogik verglichen werden.

Der Erfindung liegt die Aufgabe zugrunde, ein weiteres Verfahren zum Paralleltest von Halbleiterspeichern anzugeben, bei dem die Testmuster individuell auswählbar sind und mit dem eine genauere Angabe über die möglichen Fehler in den Speicherzellen möglich ist. Weiterhin liegt der Erfindung die Aufgabe zugrunde, eine Vorrichtung zum Betrieb des erfindungsgemäßen Verfahrens anzugeben, wobei der Schaltungsaufwand zur Implementierung in den Halbleiterspeichern gering sein sollte und Eingriffe in die bestehende Speicherarchitektur nicht notwendig sind.

Diese Aufgaben werden erfindungsgemäß durch die Merkmale des Patentanspruches 1 für das Verfahren und durch die Merkmale des Patentanspruches 6 für die erforderliche Paralleltestvorrichtung gelöst.

Weitere Ausgestaltungen des erfindungsgemäßen Verfahrens sowie der zugehörigen Vorrichtung sind Gegenstand der Unteransprüche und werden dort im einzelnen wiedergegeben.

Die mit der Erfindung erzielten Vorteile liegen insbesondere darin, daß durch die hohe Flexiblität in der Wahl der Testmuster Speicherzellen in unmittelbarer Umgebung zueinander sicher ausgetestet werden können. Durch die Anwendung des erfindungsgemäßen Verfahrens ist es möglich Einzelbit und Mehrbitfehler zuverlässig zu unterscheiden und bei Einzelbitfehlern die Fehlerbitadresse anzugeben. Weiterhin ist es durch die freie Wahl der Testmuster und bei entsprechender Konfiguration der Vorrichtung möglich eine größere Anzahl von Speicherzellen parallel auszutesten, was zu einer weiteren Reduzierung der Testzeit für den betreffenden Halbleiterspeicher führt. Der erforderliche Schaltungsaufwand für die Paralleltestvorrichtung ist gering und flexibel an die Konfiguration des jeweiligen Speichers anpaßbar.

Die Erfindung wird nachfolgend anhand der Zeichnungen näher erläutert. Dabei zeigen:

Figur 1     das Prinzip des erfindungsgemäßen Verfahrens zur Ermittlung der Ergebnisvektoren,

Figur 2     den Gesamtaufbau einer beispielhaften Paralleltestvorrichtung mit 16 Bit Breite, zur Ermittlung der Ergebnisvektoren, wobei als fehlerkorrigierender Code der Hammingcode eingesetzt wurde,

Figur 3     den Aufbau einer beispielhaften 16 Bit Paritätsprüfschaltung zur Ermittlung eines Bits eines Ergebnisvektors,

Figur 4     eine erste Möglichkeit zur Realisierung eines Paritätsprüfmoduls für die Paritätsprüfschaltung,

Figur 5     eine zweite Möglichkeit zur Realisierung eines Paritätsprüfmoduls für die Paritätsprüfschaltung.

Figur 6     die Teilschaltung einer minimierten Paralleltestvorrichtung mit 16 Bit Breite.

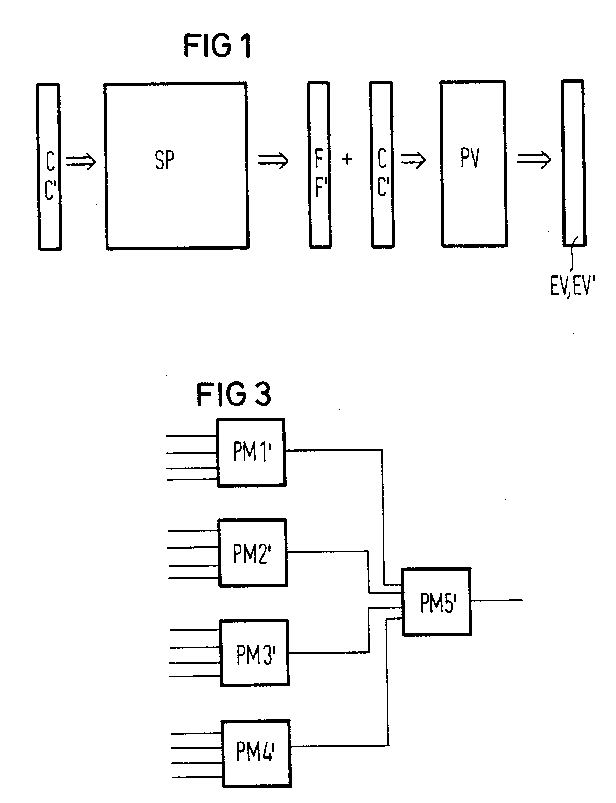

Für das erfindungsgemäße Verfahren zum Paralleltest von Speicherzellen eines Speichers wird dieser in Gruppen von Speicherzellen aufgeteilt. Eine Gruppe von Speicherzellen wird hierbei durch die Adressierung von Wort- und Bitleitungen aktiviert und, wie in Figur 1 symbolhaft angedeutet wird, in allen Speicherzellen dieser Gruppe des Speichers SP ein Codewort C eingeschrieben. Wurden für die Auswahl von den Gruppen der Speicherzellen lediglich die Wortleitungen eines Halbleiterspeichers herangezogen, so wird das Codewort C demzufolge in allen an diesen Wortleitungen angeschlossenen Speicherzellen eingeschrieben. Im nächsten Verfahrensschritt werden diese Speicherzellen der betreffenden Gruppe ausgelesen und die ausgelesenen Informationen F + C einer Paralleltestvorrichtung PV zugeführt. Am Ausgang dieser Paralleltestvorrichtung PV

2

EP 0 400 179 B1

wird hierbei ein erster Ergebnisvektor EV ermittelt. Die Bezeichung der ausgelesenen Informationen mit F + C soll darauf hindeuten, daß das Codewort C durch einen Fehleranteil F aufgrund defekter Speicherzellen verfälscht wurde. Um jeweils eine Speicherzelle auf ihre Fähigkeit zu testen ein Low- und High-Signal zu speichern wird neben dem ersten Ergebnisvektor auch ein zweiter Ergebnisvektor benötigt. Hierzu wird aus dem Codewort C das Einerkomplement gebildet, so daß ein weiteres Codewort C′ entsteht, welches ebenfalls in die betreffenden Speicherzellen der Gruppe eingeschrieben wird. Alle Speicherzellen dieser Gruppe werden anschließend wieder ausgelesen und die ausgelesenen Informationen C′ + F′ werden wiederum der Paralleltestvorrichtung PV zugeführt, wodurch der zweite Ergebnisvektor EV′ ermittelt wird. Aus beiden Ergebnisvektoren läßt sich anschließend eine Bestimmung der Fehleranzahl und falls genau ein Fehler vorliegt eine Bestimmung der mit dem Fehler behafteten Speicherzelle innerhalb der betreffenden Gruppe durchführen.

In der gleichen Art und Weise werden für die übrigen Gruppen von Speicherzellen des Speichers erste und zweite Ergebnisvektoren ermittelt, so daß im Abschluß eine Aussage über die Fehleranzahl und über die Bestimmung der mit dem Fehler behafteten Speicherzelle innerhalb der übrigen Gruppen möglich ist.

Da die Information über den Inhalt aller Speicherzellen einer Gruppe zur gleichen Zeit zur Verfügung stehen, lassen sich die Methoden der fehlerkorrigierenden Codes anwenden, um eine oder mehrere Speicherzellen mit fehlerhaften Eigenschaften zu erkennen und sogar zu lokalisieren. Als Testmuster werden sogenannte Codeworte benutzt, die sich optimal mit Hilfe des Hammingcodes gewinnen lassen. Die Gewinnung anderer Codewörter aus der Theorie der fehlerkorrigierenden Codes ist ebenfalls denkbar, jedoch soll auf diese hier nicht näher eingegangen werden.

Zur besseren Verständlichkeit des erfindungsgemäßen Verfahrens wird nun im folgenden eine kurze Einleitung zur Theorie der fehlererkennenden Codes gegeben.

Ein binäres Datenwort C der Länge m heißt Codewort wenn die modulo 2 Multiplikation des Datenwortes C mit einer vorgegebenen binären Prüfmatrix H den Nullvektor 0, als Ergebnisvektor liefert. Die Prüfmatrix H besitzt m Spalten und ceil (1d(m + 1)) Zeilen. Hierbei ist ceil (x) = N die kleinste natürliche Zahl für die gilt N größer gleich x. Die Matrix muß dabei zwei Bedingungen erfüllen. Keine Spalte darf nur Nullen enthalten und keine Spalte darf mehrfach vorkommen. Die Codiergleichung lautet daher:

$$H * C = 0$$

Ist das Codewort durch einen Fehler gestört, so kann das gestörte Codewort durch die Summe des ungestörten Codewortes C und eines Fehlervektors F dargestellt werden.

$$H * (C + F) = H * C + H * F = 0 + H * F = S$$

Die Multiplikation eines gestörten Codewortes mit der Prüfmatrix führt zu dem Syndrom S, das auch als Ergebnisvektor bezeichnet wird. Der Ergebnisvektor ist nicht von dem Codewort sondern nur von dem aufgetretenen Fehlervektor F abhängig. Bezeichnet man die Spalten der Prüfmatrix H mit $h_i$ und die Komponenten des Fehlervektors F mit $f_i$, so kann man auch schreiben:

$$H * F = \sum_{i=1}^{m} h_i * f_i$$

Ist das Codewort nur an einer Stelle gestört, zum Beispiel an der Position j, so ist nur die j-te Komponente des Fehlervektors ungleich 0. Es gilt dann:

$f_i = 0$ für i ungleich j
$f_i = 1$ für i gleich j

Hieraus folgt für das Syndrom S:

$$S = H * F = \sum_{i=1}^{m} h_i * f_i = h_j$$

Tritt genau ein Fehler an der Position j auf, so ist das Syndrom gleich der j-ten Spalte der Prüfmatrix H. Ist nun die Prüfmatrix so aufgebaut, daß der Spalteninhalt der binär dargestellten Spaltenposition entspricht, so gibt das Syndrom direkt die Adresse des fehlerhaften Bits wieder.

Wie bereits angegeben wird der erste und zweite Ergebnisvektor, die in der Theorie der fehlererkennenden Codes den Syndromen entsprechen, aus einer modulo 2 Multiplikation zwischen den aus der Speicherzelle der Gruppe ausgelesenen Informationen und einer durch den fehlerkorrigierenden Code vorgegebenen Prüfmatrix gebildet. Die ausgelesenen Informationen liefern genau dann wieder das ungestörte Codewort, falls alle Speicherzellen der Gruppe fehlerfrei sind und liefern ein gestörtes Codewort falls mindestens eine fehlerhafte

3

Speicherzelle innerhalb der Gruppe aufgetreten ist.

Die Prüfmatrix H für einen 16 Bit Paralleltest, der beispielsweise für 16 M oder 64 M Speicher eingesetzt werden kann, enthält in der ersten Zeile nur Einsen. Bei genau zwei Fehlern ist das Syndrom gleich der Summe zweier Spalten der Codiermatrix. Das erste Element des Syndroms ist dann Null und zeigt so den Zweifachfehler an. Die Zeilen 2 bis 5 geben die Position der Spalte als Binärzahl an, wobei Zeile 2 den niederwertigsten Bit $(2^0)$ und Zeile 5 dem höchstwertigen Bit $(2^3)$ entspricht. Bei genau einem Fehler geben die Elemente 2 bis 5 des Syndroms die Fehlerposition an. Die Prüfmatrix H für einen 16 Bit Paralleltest mit Hilfe des Hammingcodes läßt sich wie folgt angeben:

$$H = \begin{bmatrix} 1 & 1 & 1 & 1 & 1 & 1 & 1 & 1 & 1 & 1 & 1 & 1 & 1 & 1 & 1 & 1 \\ 0 & 1 & 0 & 1 & 0 & 1 & 0 & 1 & 0 & 1 & 0 & 1 & 0 & 1 & 0 & 1 \\ 0 & 0 & 1 & 1 & 0 & 0 & 1 & 1 & 0 & 0 & 1 & 1 & 0 & 0 & 1 & 1 \\ 0 & 0 & 0 & 0 & 1 & 1 & 1 & 1 & 0 & 0 & 0 & 0 & 1 & 1 & 1 & 1 \\ 0 & 0 & 0 & 0 & 0 & 0 & 0 & 0 & 1 & 1 & 1 & 1 & 1 & 1 & 1 & 1 \end{bmatrix}$$

Da sich ein Codewort aus einem Datenvektor mit frei wählbaren Datenbits und einem berechneten Redundanzvektor zusammensetzt, muß man vor Einführung des Testverfahrens einmal einen Satz von Codeworten berechnen. Dies geschieht mit Hilfe einer modulo 2 Matrizenmultiplikation zwischen einer durch den fehlerkorrigierenden Code vorgegebenen Redundanzmatrix und dem Datenvektor. Der einmal berechnete Codewort-Satz kann dann immer wieder verwendet werden. Im folgenden ist die Vorschrift zur Erzeugung der Codeworte für einen 16 Bit Paralleltest angegeben, wobei das 16 stellige binäre Codewort sich aus 11 frei wählbaren Datenbits und 5 berechneten Redundanzbits zusammensetzt.

$$\begin{bmatrix} R0 \\ R1 \\ R2 \\ R4 \\ R8 \end{bmatrix} = \begin{bmatrix} 1 & 1 & 1 & 0 & 1 & 1 & 0 & 1 & 0 & 0 & 1 \\ 1 & 1 & 0 & 1 & 1 & 0 & 1 & 0 & 1 & 0 & 1 \\ 1 & 0 & 1 & 1 & 0 & 1 & 1 & 0 & 0 & 1 & 1 \\ 0 & 1 & 1 & 1 & 0 & 0 & 0 & 1 & 1 & 1 & 1 \\ 0 & 0 & 0 & 0 & 1 & 1 & 1 & 1 & 1 & 1 & 1 \end{bmatrix} * \begin{bmatrix} D3 \\ D5 \\ D6 \\ D7 \\ D9 \\ D10 \\ D11 \\ D12 \\ D13 \\ D14 \\ D15 \end{bmatrix}$$

Die Position der Daten und Redundanzbits werden durch die Wahl des Codes vorgegeben. In diesem Falle lauten sie

C = [R0 R1 R2 D3 R4 D5 D6 D7 R8 D9 D10 D11 D12 D13 D14 D15]$^T$

Da 11 Datenbits frei wählbar sind, ergibt sich für den Paralleltest eine Auswahl von $2^{11} = 2048$ verschiedenen Testmustern. Diese hohe Flexibilität bezüglich der Testmuster ist insbesondere für den Test von Speicherzellen in der Nachbarschaftsumgebung vorteilhaft. Hierbei kommt es aufgrund der räumlichen Lage der Speicherzellen zu einer gegenseitigen kapazitiven Beeinflussung für das ein Testmuster mit hoher "0", "1" Sequenz eingesetzt werden sollte.

Die Ergebnisvektoren bei der Auswertung ergeben sich als eine gewichtete Summe über die verschiedenen Spalten der Codiermatrix H, in Abhängigkeit von der Beschaffenheit der aufgetretenen Fehler. Beide Ergebnisvektoren weisen ein Fehlerbit für eine gerade bzw. ungerade Anzahl von Fehler und Bits zur Einzelfehleradresse auf. Für die Auswertung der Ergebnisvektoren gilt, daß innerhalb einer Gruppe alle Speicherzellen dann funktionsfähig sind, falls der erste und zweite Ergebnisvektor Null ist, daß sich genau eine Speicherzelle aus der Gruppe als funktionsunfähig feststellen läßt, falls einer der beiden Ergebnisvektoren Null und der andere der beiden Ergebnisvektoren einen Fehler anzeigt. In diesem Falle ist die Adresse der funktionsunfähigen Speicherzelle innerhalb der Gruppe durch die Bits der Einzelfehleradresse in dem von Null verschiedenen Ergebnisvektor angegeben. Sind genau zwei Speicherzellen innerhalb einer Gruppe funktionsunfähig, so ist dies dadurch zu erkennen, daß einer der beiden Ergebnisvektoren gleich Null und der andere Ergebnisvektor zwei Fehler anzeigt. Hierbei ist die Fehleradresse innerhalb der Gruppe von Speicherzellen nicht mehr zu ermitteln. Schließlich sind innerhalb der Gruppe zwei oder mehr Speicherzellen defekt, wenn der erste und zweite Ergebnisvektor je einen Fehler mit unterschiedlicher Einzelbitfehleradresse anzeigt, für alle übrigen Bitkombinationen der Ergebnisvektoren sind mehr als zwei Speicherzellen innerhalb der betreffenden Gruppe funktionsunfähig. Da das Codewort mit Hilfe des Hammingcodes gebildet wurde zeigt ein Ergebnisvektor genau dann eine ungerade Anzahl von Fehlern an, falls das erste Bit desselbigen ungleich Null ist. Eine geradzahlige Anzahl von Fehlern hingegen wird angezeigt, wenn ein Ergebnisvektor im ersten Bit desselbigen eine Null aufweist und die übrigen Bits hierbei ungleich Null sind.

Wurde ein Fehler detektiert und lokalisiert, so muß diese Speicherzelle noch einmal überprüft werden, da auch eine ungerade Anzahl von Fehlern größer 1 zur gleichen Diagnose hätte führen können. Dies rührt daher, daß die Wahl des fehlererkennenden Codes, in diesem Falle der Hammingcode, zur Korrektur von Einzelbitfehlern und zur Erkennung von zwei Bitfehlern konstruiert wurde. Bei Auftreten von mehr als zwei Fehlern innerhalb der Speicherzellen einer Gruppe erhält man daher irrelevante Ergebnisse. Treten bei dem beschriebenen Verfahren also ungeradzahlige Anzahl von Fehlern größer 1 auf, so wird fälschlicherweise ein Einzelbitfehler angezeigt. Treten eine geradzahlige Anzahl von Fehler größer 2 auf, so wird in diesem Falle ein Zweifachfehler detektiert. Auch das Auftreten von verdeckten Fehlern ist möglich. Unter der Voraussetzung, daß alle möglichen Fehlerkombinationen mit der gleichen Häufigkeit auftreten, wird in drei Prozent aller möglichen Fehlerfälle, nämlich dann, wenn der Fehlervektor selbst wieder ein Codewort ist, Fehlerfreiheit angezeigt. Da allerdings dann sowohl das Codewort, als auch der invertierte Codewort von einem Fehler, der in beiden Fällen wieder selbst ein Codewort ist, überlagert sein muß, ist die Wahrscheinlichkeit für das Auftreten eines verdeckten Fehlers sehr gering. Die Wahrscheinlichkeit für das Auftreten eines solchen Fehlers beträgt für die Codewörter der Länge m, $1:2^N$ (hierbei ist ceil (1d (m + 1)) = N). Da weiterhin nicht alle Fehleranzahlen mit einer gleichen Häufigkeit auftreten, sondern bei einem stabilen Fertigungsprozeß die Einzelbitfehler und die Bitleitungsfehler dominant sind, liegt die Trefferquote des erfindungsgemäßen Paralleltestverfahrens über 99,9 Prozent. Bitleitungsfehler wirken auf das Paralleltestverfahren in diesem Falle wie Einzelbitfehler.

Im folgenden soll nun ein Beispiel für einen 16 Bit breiten Paralleltest angegeben werden, der für die Überprüfung von Speicherzellen innerhalb eines 16-M oder 64-M großen Halbleiterspeichers eingesetzt werden kann. Für diesen 16 Bit Paralleltest sind 11 Bit im Codewort frei wählbar, und stellen den Datenvektor dar, während die restlichen 5 Bit, die den sogenannten Redundanzvektor bilden, berechnet werden müssen. Als 11stelliger Datenvektor D wurde

$$D = \begin{bmatrix} D3 & D5 & D6 & D7 & D9 & D10 & D11 & D12 & D13 & D14 & D15 \end{bmatrix}^T$$

$$= \begin{bmatrix} 0 & 1 & 0 & 0 & 0 & 0 & 0 & 0 & 1 & 0 & 1 \end{bmatrix}^T$$

gewählt.

Zur Berechnung des Redundanzvektors wird nun der 11-stellige Datenvektor D mit der fest vorgegebenen Redundanzmatrix modulo 2 multipliziert.

$$\begin{bmatrix} R0 \\ R1 \\ R2 \\ R4 \\ R8 \end{bmatrix} = \begin{bmatrix} 1 & 1 & 1 & 0 & 1 & 1 & 0 & 1 & 0 & 0 & 1 \\ 1 & 1 & 0 & 1 & 1 & 0 & 1 & 0 & 1 & 0 & 1 \\ 1 & 0 & 1 & 1 & 0 & 1 & 1 & 0 & 0 & 1 & 1 \\ 0 & 1 & 1 & 1 & 0 & 0 & 0 & 1 & 1 & 1 & 1 \\ 0 & 0 & 0 & 0 & 1 & 1 & 1 & 1 & 1 & 1 & 1 \end{bmatrix} * \begin{bmatrix} 0 \\ 1 \\ 0 \\ 0 \\ 0 \\ 0 \\ 0 \\ 0 \\ 0 \\ 1 \\ 0 \\ 1 \end{bmatrix} = \begin{bmatrix} 0 \\ 1 \\ 1 \\ 1 \\ 0 \end{bmatrix}$$

Der 5-stellige Redundanzvektor läßt sich also beschreiben zu $R = [0 \quad 1 \ 1 \ 1 \ 0]^T$.

Zur Bildung des 16-stelligen Codewortes, welches in die Speicherzellen einer ausgewählten Gruppe eingeschrieben wird, wird nun der 11-stellige Datenvektor und der 5-stellige Redundanzvektor wie folgt zusammengesetzt:

$$C = [R0 \ R1 \ R2 \ D3 \ R4 \ D5 \ D6 \ D7 \ R8 \ D9 \ D10 \ D11 \ D12 \ D13 \ D14 \ D15]^T$$

$$= [0 \ 1 \ 1 \ 0 \ 1 \ 1 \ 0 \ 0 \ 0 \ 0 \ 0 \ 0 \ 0 \ 1 \ 0 \ 1]^T$$

Dieses Beispiel-Codewort wird nun in die zu prüfende 16-Bit-Gruppe des Speichers eingeschrieben.

Anschließend werden die aus den Speicherzellen der betreffenden Gruppe wieder ausgelesenen Informationen der Paralleltestvorrichtung zugeführt, wobei die Fehleranzahl und gegebenenfalls die Fehleradresse ermittelt wird. Entsprechen die ausgelesenen Informationen genau dem eingegebenen Codewort so liegt kein Fehler vor. In diesem Falle ist der Ergebnisvektor der Null-Vektor. Dies läßt sich auch dadurch zeigen, daß man die ausgelesenen Informationen modulo 2 mit der Prüfmatrix H multipliziert.

$$H*C = \begin{bmatrix} 1 & 1 & 1 & 1 & 1 & 1 & 1 & 1 & 1 & 1 & 1 & 1 & 1 & 1 & 1 & 1 \\ 0 & 1 & 0 & 1 & 0 & 1 & 0 & 1 & 0 & 1 & 0 & 1 & 0 & 1 & 0 & 1 \\ 0 & 0 & 1 & 1 & 0 & 0 & 1 & 1 & 0 & 0 & 1 & 1 & 0 & 0 & 1 & 1 \\ 0 & 0 & 0 & 0 & 1 & 1 & 1 & 1 & 0 & 0 & 0 & 0 & 1 & 1 & 1 & 1 \\ 0 & 0 & 0 & 0 & 0 & 0 & 0 & 0 & 1 & 1 & 1 & 1 & 1 & 1 & 1 & 1 \end{bmatrix} * \begin{bmatrix} 0 \\ 1 \\ 1 \\ 0 \\ 1 \\ 1 \\ 0 \\ 0 \\ 0 \\ 0 \\ 0 \\ 0 \\ 0 \\ 1 \\ 0 \\ 1 \end{bmatrix} = \begin{bmatrix} 0 \\ 0 \\ 0 \\ 0 \\ 0 \end{bmatrix}$$

Diese modulo 2 Matrizenmultiplikation wird in der später beschriebenen Realisierung durch die Paralleltestvorrichtung und durch eine ausgewählte feste Verdrahtung zwischen den Speicherzellen und der Paralleltestvorrichtung realisiert.

Ist eine Speicherzelle in der ausgewählten Gruppe defekt, so macht sich dies darin bemerkbar, daß sich die ausgelesenen Informationen nicht mit dem angegebenen Codewort decken. In diesem Beispiel nun soll die Position 10 innerhalb der Gruppe der Speicherzellen funktionsunfähig sein. Dies bedeutet jedoch, daß das Codewort genau an der Position 10 gestört ist.

$$F = \begin{bmatrix} F0 & F1 & F2 & F3 & F4 & F5 & F6 & F7 & F8 & F9 & F10 & F11 & F12 & F13 & F14 & F15 \end{bmatrix}^T$$
$$= \begin{bmatrix} 0 & 0 & 0 & 0 & 0 & 0 & 0 & 0 & 0 & 0 & 1 & 0 & 0 & 0 & 0 & 0 \end{bmatrix}^T$$

Hieraus folgt für die ausgelesenen Informationen, daß sie den Wert C + F = [0 1 1 0 1 1 0 0 0 0 1 0 0 1 0 1]$^T$ besitzen. Bei der Auswertung innerhalb der Paralleltestvorrichtung ergibt sich nun als Syndrom bzw. Ergebnisvektor E = [1 0 1 0 1]$^T$. Der Ergebnisvektor ist ungleich 0, also wurde ein Fehler erkannt. Das erste Bit des Ergebnisvektors ist 1, wobei ein Einzelbitfehler vorliegt. Die Bit 2 bis Bit 5 liefern in diesem Falle die Binärzahl 1 0 1 0, wobei das Bit 2 die niedrigste Wertigkeit besitzt. Der Fehler ist also an der Position 10 des Codewortes erkannt worden und kann korrigiert werden. Mathematisch läßt sich die Auswertung innerhalb der Paralleltestvorrichtung wieder als modulo 2 Multiplikation der ausgelesenen Informationen mit der Prüfmatrix beschreiben:

7

$$H*(C+F) = \begin{bmatrix} 1 & 1 & 1 & 1 & 1 & 1 & 1 & 1 & 1 & 1 & 1 & 1 & 1 & 1 & 1 & 1 \\ 0 & 1 & 0 & 1 & 0 & 1 & 0 & 1 & 0 & 1 & 0 & 1 & 0 & 1 & 0 & 1 \\ 0 & 0 & 1 & 1 & 0 & 0 & 1 & 1 & 0 & 0 & 1 & 1 & 0 & 0 & 1 & 1 \\ 0 & 0 & 0 & 0 & 1 & 1 & 1 & 1 & 0 & 0 & 0 & 0 & 1 & 1 & 1 & 1 \\ 0 & 0 & 0 & 0 & 0 & 0 & 0 & 0 & 1 & 1 & 1 & 1 & 1 & 1 & 1 & 1 \end{bmatrix} * \begin{bmatrix} 0 \\ 1 \\ 1 \\ 0 \\ 1 \\ 1 \\ 0 \\ 0 \\ 0 \\ 0 \\ 1 \\ 0 \\ 0 \\ 1 \\ 0 \\ 1 \end{bmatrix} = \begin{bmatrix} 1 \\ 0 \\ 1 \\ 0 \\ 1 \end{bmatrix}$$

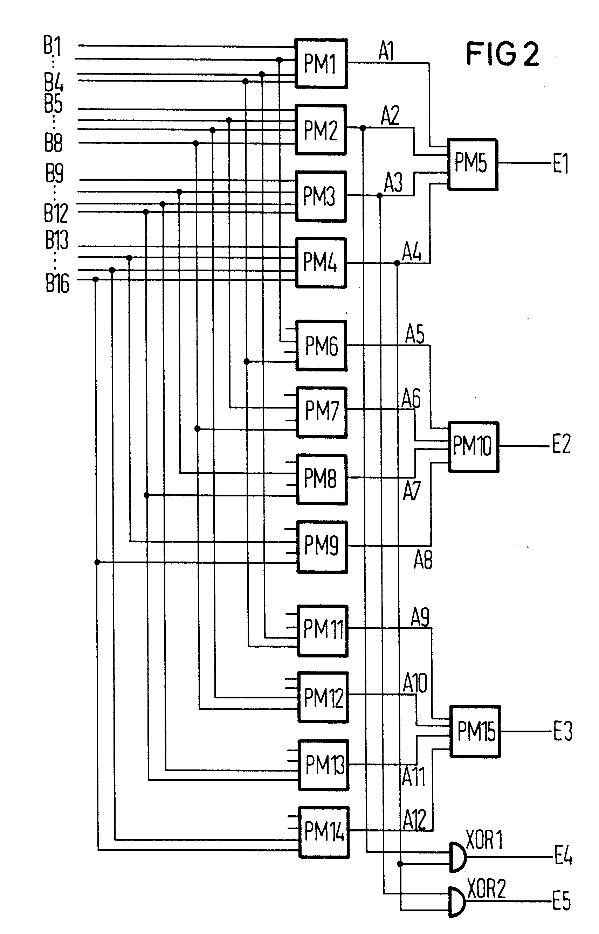

Figur 2 zeigt den Gesamtaufbau einer beispielhaften Paralleltestvorrichtung mit einer Breite von 16 Bit zur Ermittlung des gesamten Ergebnisvektors, wobei als fehlerkorrigierender Code der Hammingcode eingesetzt wurde. Die Paralleltestvorrichtung ist so aufgebaut, daß mit ihr eine modulo 2 Multiplikation mit den aus den Speicherzellen ausgelesenen Informationen und der Prüfmatrix durchgeführt werden kann. Da die ausgelesenen Informationen mathematisch einem Vektor entsprechen ist die modulo 2 Matrizenmultiplikation zwischen den ausgelesenen Informationen und der Prüfmatrix gleichbedeutend mit einer gewichteten Paritätsprüfung der ausgelesenen Informationen. Sie wird dadurch durchgeführt, daß die Komponenten der ausgelesenen Informationen berücksichtigt werden, die mit einer 1 des Vektors in der Prüfmatrix korrespondieren. Die Anzahl der Zeilen in der Prüfmatrix geben hierbei an wie oft eine Paritätsbildung durchzuführen ist, wobei für jede Paritätsbildung eine Zeile der Prüfmatrix als Gewicht Verwendung findet. Jede der fünf Zeilen der Prüfmatrix entspricht somit einer Paritätsprüfschaltung. Eine 1 in der Matrixzeile entspricht dem Vorhandensein eines Dateneingangs, eine 0 bedeutet, daß das zugehörige Bit des Datenvektors nicht in die Paritätsberechnung eingeht. So wird in der ersten Zeile die Parität über die gesamten auszulesenden Informationen gebildet, während in der zweiten Zeile der Prüfmatrix nur jedes zweite Bit der ausgelesenen Informationen in die Paritätsberechnung einbezogen wird. Die 16 Bit der ausgelesenen Informationen stehen an den I/O-Leitungen des Halbleiterspeichers als 4 Bit Worte zur Verfügung. Es ist daher günstig, die parallele Testvorrichtung, welche aus maximal fünf Paritätsprüfschaltungen mit bis zu 16 Eingängen besteht, baumförmig aus 4 Bit Paritätsmodulen aufzubauen und räumlich zu trennen. Die Teilergebnisse der vierten und fünften Zeile der Codiermatrix stehen schon durch die Auswertung der ersten Zeile zur Verfügung. Somit sind zum gesamten Aufbau lediglich drei Paritätsprüfschaltungen sowie zwei zusätzliche XOR-Gatter XOR1 und XOR2 erforderlich. Die erste Paritätsprüfschaltung gebildet aus den Paritätsprüfmodulen PM1, PM2, PM3, PM4 und PM5 liefert an ihrem Ausgang das erste Bit E1 des Ergebnisvektors. Die zweite Paritätsprüfschaltung, aufgebaut aus den Paritätsprüfmodulen PM6, PM7, PM8, PM9 und PM10 liefert das zweite Bit E2 des Ergebnisvektors, während die dritte Paritätsprüfschaltung, bestehend aus den Paritätsprüfmodulen PM11, PM12, PM13, PM14 und PM15 das dritte Bit E3 des Ergebnisvektors liefert. An den Ausgängen des XOR-Gatters XOR1 liegt das vierte Bit E4 und am Ausgang des XOR-Gatters XOR2 das fünfte Bit E5 des Ergebnisvektors. Jede Paritätsprüfschaltung ist baumförmig aufgebaut, so daß der Ausgang A1 von PM1, der Ausgang A2 von PM2, der Ausgang A3 von PM3 und der Ausgang A4 von PM4 auf je einen Eingang des Paritätsprüfmoduls PM5 geschaltet ist, während der Ausgang A5 vom Paritätsprüfmodul PM6, A6 von PM7, A7 von PM8 und A8 von PM9 an das Paritätsprüfmodul PM10 angeschlossen ist. Der Ausgang A9 von PM11, der Ausgang A10 von PM12, der Ausgang A11 von PM13, sowie der Ausgang A12 von PM14 sind schließlich mit je einem Eingang des Paritätsprüfmoduls PM15 verschaltet. Der Ausgang A2 und der Ausgang A4 sind weiterhin auf jeweils einem Eingang des XOR-Gatters XOR1 und der Ausgang A3 und wiederum der Ausgang A4 auf je einem Eingang des XOR-Gatters XOR2 zu schalten. Hierbei ist zu beachten, daß sich als Paritätsprüfschaltung für zwei Eingänge ein XOR Gatter als einfachste Schaltungsstruktur anbietet. Durch geschickte Strukturierung des Paritätsprüfmoduls PM5 ist es möglich die logische Funktion des Gatters XOR2 mit zu implementieren, so daß dieses nicht mehr zusätzlich aufgebaut werden muß. Da wie bereits angesprochen die erste Zeile der Prüfmatrix ausschließlich mit Einswerten besetzt ist wird die Parität über die gesamten auszulesenden Informationen gebildet. Hierzu ist das Paritätsprüfmodul PM1 mit seinen Eingängen mit den Bits B1, B2, B3 und B4 der auszulesenden Informationen, das Paritätsprüfmodul PM2 mit seinen Eingängen mit den Bits B5, B6, B7 und B8 der auszulesenden Informationen und die Bits B9, B10, B11 und B12 sind mit den Eingängen des Paritätsprüfmoduls PM3 zu verschalten. Die Bits B13, B14 und B15 sowie B16 sind an das Paritätsprüfmodul PM4 anzuschließen. Die zweite Zeile der Prüfmatrix weist wechselweise eine 0, 1-Kombination auf, so daß hierfür das Paritätsprüfmodul PM6 mit seinem ersten und dritten Eingang nicht in die Paritätsberechnung eingeht, während der zweite Eingang mit dem Bit B2 und der vierte Eingang mit dem Bit B4 der auszulesenden Informationen verschaltet ist. Für das Paritätsprüfmodul PM7 gilt analog, daß der erste und dritte Eingang nicht beschaltet wird und der zweite Eingang an das Bit B6 und der vierte Eingang an das Bit B8 der auszulesenden Informationen anzuschließen ist. Das Paritätsprüfmodul PM8 sowie das Paritätsprüfmodul PM9 sind ebenfalls mit ihren ersten und dritten Eingängen nicht beschaltet, während das Paritätsprüfmodul PM8 mit seinem zweiten Eingang mit dem Bit B10 und mit seinem vierten Eingang mit dem Bit B12 zu verschalten ist. Schließlich ist das Paritätsprüfmodul PM9 mit seinem zweiten Eingang mit dem Bit B14 und mit seinem vierten Eingang mit dem Bit B16 zu verbinden. Die dritte Zeile der Prüfmatrix weist schließlich eine 0011-Sequenz auf, so daß jeweils die ersten und zweiten Eingänge der Paritätsprüfmodule PM11, PM12, PM13 und PM14 nicht zu verschalten sind, während der dritte Eingang von PM11 mit dem Bit B3 und der vierte Eingang von PM11 mit dem vierten Bit B4 zu verschalten ist. Der dritte und vierte Eingang des Paritätsprüfmoduls PM12 schließlich ist mit dem Bit 7 bzw. Bit 8 zu verschalten und der dritte und vierte Eingang von PM13 mit dem Bit B11 bzw. B12. Schließlich ist der dritte Eingang des Paritätsprüfmoduls PM14 an das Bit B15 der vierte Eingang desselbigen an das Bit B16 der auszulesenden Informationen anzuschließen.

Wird eine andere Prüfmatrix H gewählt, so ist die Eingangsbeschaltung zwischen den Bits der ausgelesenen Informationen B1 bis B16 und den Paritätsprüfmodulen PM1 bis PM14 entsprechend dieser Prüfmatrix vorzunehmen und gegebenenfalls die XOR-Gatter XOR1, XOR2 durch zwei weitere Paritätsprüfschaltungen zu ergänzen.

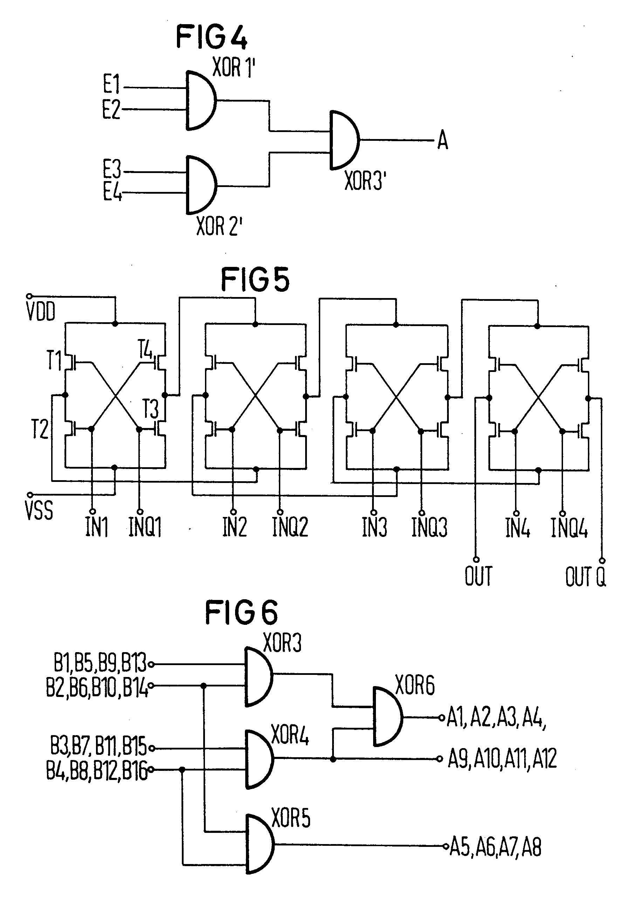

Figur 3 zeigt nochmals den Aufbau einer beispielhaften 16 Bit Paritätsprüfschaltung zur Ermittlung eines Bits eines Ergebnisvektor. Die Struktur ist in diesem Fall wieder baumförmig aus Paritätsprüfmodulen PM1′, PM2′, PM3′, PM4′und PM5′ aufgebaut. Im einzelnen sind die Ausgänge des Paritätsprüfmoduls PM1′, der Ausgang des Paritätsprüfmoduls PM2′, der Ausgang des Paritätsprüfmoduls PM3′ und der Ausgang des Paritätsprüfmoduls PM4′ auf jeweils einen Eingang des Paritätsprüfmoduls PM5′ geschaltet. Der Ausgang desselbigen liefert hierbei ein Bit eines Ergebnisvektors während an den Eingängen der Paritätsprüfmodule PM1′ bis PM4′ jeweils die ausgelesenen Informationen als ein 4-Bit-Wort angelegt werden.

Figur 4 zeigt eine erste Möglichkeit zur Realisierung eines Paritätsprüfmoduls welches aus drei XOR-Gatter XOR1′, XOR2′ und XOR3′ aufgebaut ist. Der Ausgang des XOR-Gatters XOR1′ und der Ausgang des XOR-Gatters XOR2′ sind jeweils auf einen Eingang des XOR-Gatters XOR3′ geschaltet, während die Eingänge E1, E2 des XOR-Gatters XOR1′ den ersten und zweiten Eingang des Paritätsprüfmoduls und die Eingänge E3, E4 des XOR-Gatters XOR2′ den dritten und vierten Eingang des Paritätsprüfmoduls bilden. Schließlich bildet der Ausgang A des XOR-Gatters XOR3′ den Ausgang des Paritätsprüfmoduls. Wird nun die gesamte Paritätsprüfschaltung aus XOR-Gattern aufgebaut so weist das Layout einer solchen Schaltung, aufgrund der Baumstruktur eine ungleichmäßige Flächenausnutzung auf. Mit der in Figur 5 dargestellten Schaltung hingegen wird die Realisierung eines Paritätsprüfmoduls mit gleichmäßiger Flächenausnutzung ermöglicht.

Figur 5 zeigt eine zweite Möglichkeit zur Realisierung eines Paritätsprüfmoduls die aus einer Serienschaltung von Push-Pull-Stufen besteht. Für ein Paritätsprüfmodul werden vier verkettete Push-Pull-Stufen benötigt, wobei jeweils zwei verkettete Push-Pull-Stufen eine XOR-Funktion bilden. Durch eine Serienschaltung aller vier Stufen läßt sich jedoch eine logische Funktion aufbauen, die der Schaltung nach Figur 4 entspricht. Jede Push-Pull-Stufe enthält einen ersten und zweiten Spannungseingang, einen ersten und zweiten Spannungsausgang sowie einen ersten und zweiten Dateneingang, die jeweils mit komplementären Eingangssignalen belegt werden. Der erste Spannungseingang der ersten Push-Pull-Stufe ist mit einer ersten Spannung $V_{DD}$ verschaltet, während der zweite Spannungseingang der ersten Push-Pull-Stufe mit einer zweiten Spannung, in diesem Falle Masse $V_{SS}$ verbunden ist. Der erste und zweite Spannungsausgang der vierten Push-Pull-Stufe bildet einen ersten und zweiten, jeweils komplementären Ausgang OUT, OUTQ des Paritätsprüfmoduls. Die übrigen Push-Pull-Stufen sind nun so verkettet, daß jeweils ein erster und zweiter Spannungsausgang der einen Push-Pull-Stufe mit jeweils einem ersten und zweiten Spannungseingang der anderen Push-Pull-Stufe verschaltet ist.

Beispielhaft für den Aufbau aller Push-Pull-Stufen ist die erste Stufe aus vier Feldeffekttransistoren gleichen Leitungstyps aufgebaut, wobei ein erster und zweiter Feldeffekttransistor T1, T2 eine erste Serienschaltung und ein dritter und vierter Feldeffekttransistor T3 und T4 eine zweite Serienschaltung bilden. Beide Serienschaltungen sind parallel geschaltet, wobei ein Anschluß des ersten Feldeffekttransistors T1 und ein Anschluß des vierten Feldeffekttransistors T4 einen ersten gemeinsamen Anschluß und ein Anschluß des zweiten Feldeffekttransistors T2 und ein Anschluß des dritten Feldeffekttransistors T3 einen zweiten gemeinsamen Anschluß bilden. Der erste gemeinsame Anschluß bildet hierbei den ersten Spannungseingang und ist bei der ersten Stufe mit der Spannung $V_{DD}$ verschaltet, während der zweite gemeinsame Anschluß den zweiten Spannungseingang bildet und mit der zweiten Spannung, in diesem Falle Masse $V_{SS}$ verbunden ist. Der Mittenanschluß der ersten Serienschaltung bildet hierbei einen ersten Spannungsausgang, der mit dem Spannungseingang der nächsten Push-Pull-Stufe zu verschalten ist, während der Mittenanschluß der zweiten Serienschaltung den zweiten Spannungsausgang der ersten Push-Pull-Stufe bildet und an den zweiten Spannungseingang der nächsten Push-Pull-Stufe anzuschließen ist. Der Gateanschluß des zweiten Feldeffekttransistors T2 und der Gateanschluß des vierten Feldeffekttransistors T4 sind mit dem ersten Dateneingang IN1 und der Gateanschluß des ersten Feldeffekttransistors und der Gateanschluß des dritten Feldeffekttransistors T1, T3 bilden gemeinsam den komplementären zweiten Dateneingang INQ1. Die übrigen Push-Pull-Stufen sind ebenfalls aus jeweils vier Feldeffekttransistoren gleichen Leitungstyps aufgebaut, wobei auch hier die Eingänge IN2, INQ2 sowie IN3, INQ3 und IN4, INQ4 jeweils komplementäre Dateneingänge darstellen.

Zur Funktionsweise der verketteten Push-Pull-Stufen sei stellvertretend hierfür die der ersten Stufe beschrieben. Am ersten Dateneingang IN1 soll ein Highsignal und am ersten invertierten Dateneingang INQ1 ein Lowsignal anliegen. Beim Anlegen dieser Eingangssignale leiten die Feldeffekttransistoren T2 sowie T4 und die Feldeffekttransistoren T1 und T3 sperren. Demzufolge ist der erste Spannungsausgang, der sich am Mittenanschluß zwischen den beiden Feldeffekttransistoren T1 und T2 befindet mit einer Spannung $V_{SS}$, gleich Masse, beschaltet, während hingegen der zweite Spannungsausgang am Mittenabgriff zwischen den beiden Feldeffekttransistoren T3 und T4 mit der Spannung $V_{DD}$ belegt ist. In dem Falle, in dem der erste Dateneingang IN1 mit einem Lowsignal und der komplementäre zweite Dateneingang INQ1 mit einem Highsignal beschaltet wird liegt an dem ersten Spannungsausgang ein Signal mit der Spannung $V_{DD}$ und am zweiten Spannungsausgang ein Signal mit der Spannung $V_{SS}$. Durch die Verkettung der Push-Pull-Stufen erreicht man das beim An liegen einer geraden Anzahl von High- bzw. Lowsignalen an den Eingängen IN1, IN2, IN3 oder IN4 bzw. dessen komplementären Dateneingängen am Ausgang OUT dieses Paritätsprüfmoduls die Spannung $V_{SS}$ und am Ausgang OUTQ die Spannung $V_{DD}$ anliegt. Wird hingegen eine ungerade Anzahl von High- und damit auch von Lowsignalen an diesen bzw. den komplementären Dateneingängen angelegt, so erscheint am Ausgang OUT ein Spannungssignal das $V_{DD}$ entspricht, während am Ausgang OUTQ ein Spannungssignal mit $V_{SS}$ erscheint. Das logische Ausgangsverhalten dieser vier verketteten Push-Push-Stufen entspricht somit genau den drei beschalteten XOR-Gattern in Figur 4.

Wie bereits angegeben bilden zwei verkettete Push-Pull-Stufen ein XOR-Gatter, und vier ein Paritätsprüfmodul. Es sei ebenfalls darauf hingewiesen, daß es möglich ist, mit Hilfe von verketteten Push-Pull-Stufen seriell eine Paritätsprüfschaltung zur Ermittlung eines Bits eines Ergebnisvektors aufzubauen. Hierzu sind insgesamt 16 miteinander verkettete Push-Pull-Stufen nötig, wobei die einzelnen Stufen wie in der Figur 5 dargestellten Weise miteinander verschaltet werden.

Da jede Zeile der Prüfmatrix einer Paritätsprüfschaltung entspricht kann durch Minimierungsschritte die Paralleltestvorrichtung in ihrem Schaltungsaufwand optimiert werden. Teilt man die Prüfmatrix in Viererabschnitte so ergeben sich vier Abschnitte zu je vier Spalten, die in fünf Zeilen unterteilt werden können. Man erkennt hierbei daß die Zeile 1 bis Zeile 3 dieser Viererabschnitte der Prüfmatrix gleich sind, was bedeutet, daß die Paritätsprüfschaltungen in allen vier Abschnitten identisch sein können. Dies kommt insbesondere einem modularen Aufbau sehr zugute. Figur 6 zeigt nun eine Teilschaltung der minimierten Paralleltestvorrichtung mit einer 16 Bit-Breite. Die Paritätsprüfmodule PM1 bis PM4, PM6 bis PM9 und PM11 bis PM14 aus der Figur 2 werden hierbei durch vier solcher Schaltungen nach Figur 6 ersetzt. Die erste Teilschaltung, ist jeweils mit den Bits B1, B2, B3 und B4 der aus den Speicherzellen ausgelesenen Informationen zu verschalten, während die zweite Teilschaltung mit den Bits B5, B6, B7 und B8, die dritte Teilschaltung mit den Bits B9, B10, B11 und B12 und schließlich die vierte Teilschaltung mit den Bits B13, B14, B15 und B16 zu beschalten ist. An den Ausgängen der ersten Teilschaltung liegen nun die zu A1, A5 und A9 zu der in Figur 2 korrespondierenden Ausgänge, während an den Ausgängen der zweiten Teilschaltung Ausgangssignale von A2, A6 und A10 anliegen. Die dritte Teilschaltung liefert die Ausgänge A3, A7 und A11 und die vierte Teilschaltung A4, A8 und A12. Die Verschaltung dieser Ausgänge mit den Paritätsprüfmodulen PM5, PM10, PM15 sowie den zusätzlichen zwei XOR-Gattern XOR1 und XOR2 aus der Figur 2 ist wie dort vorzunehmen um eine vollständige Paralleltestvorrichtung aufzubauen. Eine einzelne Teilschaltung wird nun mit Hilfe von vier XOR-Gattern XOR3, XOR4, XOR5 und XOR6 aufgebaut. Hierbei liegen die ersten drei XOR-Gatter XOR3, XOR4 und XOR5 im Eingangsbereich, während das vierte XOR-Gatter XOR6 den beiden Gattern XOR3 und XOR4 nachgeschaltet ist. Die ersten beiden Eingänge, die mit B1 und B2 bzw. B5, B6 usw. verschaltet sind werden auf das XOR-Gatter XOR3 geschaltet, während auf das XOR-Gatter XOR4 die Bits B3, B4, bzw. B7, B8 usw. anzuschließen sind. Das dritte XOR-Gatter XOR5 schließlich wird mit Hilfe jeweils des zweiten Anschlusses der beiden XOR-Gatter beschaltet, so daß an ihm die Eingänge B2, B4 bzw. B6, B8 usw. anliegen. Der Ausgang des XOR-Gatters XOR3 und der Ausgang des XOR-Gatters XOR4 werden jeweils auf einen der Eingänge des XOR-Gatters XOR6 geschaltet, dessen Ausgang den Ausgang A1 in der ersten Teilschaltung bzw. A2 in der zweiten Teilschaltung usw., liefert. Der Ausgang des XOR-Gatters XOR4 in der ersten Teilschaltung bildet den Ausgang A9, bzw. in der zweiten Teilschaltung den Ausgang A10 usw. Schließlich stellt der Ausgang XOR5 den Ausgang A5 in der ersten Teilschaltung bzw. A6 in der zweiten Teilschaltung und entsprechend die Ausgänge A7 und A8 in der dritten und vierten Teilschaltung dar. Durch die in Figur 6 dargestellte Teilschaltung ist es nun möglich den Eingangsbereich mit 4 x 4 also insgesamt 16 Gattern aufzubauen, was insbesondere eine erhöhte Platzersparnis beim Aufbau der Paralleltestvorrichtung darstellt.

## Patentansprüche

1.  Verfahren zum Paralleltest von Speicherzellen eines Speichers, wobei der Speicher in Gruppen von Speicherzellen aufgeteilt wird, und eine Gruppe von Speicherzellen durch Adressierung von Wort- und/oder Bitleitungen des Speichers aktiviert werden, bei dem jeweils in allen Speicherzellen der Gruppe ein Testmuster eingeschrieben und jeweils alle Speicherzellen der Gruppe anschließend ausgelesen werden und die ausgelesenen Informationen einer Paralleltestvorrichtung zugeführt werden, wodurch ein erstes Ergebnis ermittelt wird, bei dem aus dem Testmuster ein weiteres Testmuster gebildet wird und das weitere Testmuster in allen Speicherzellen derselben Gruppe eingeschrieben und aus allen Speicherzellen derselben Gruppe anschließend wieder ausgelesen werden und die ausgelesenen weiteren Informationen der Paralleltestvorrichtung zugeführt werden, wodurch ein zweites Ergebnis ermittelt wird, **dadurch gekennzeichnet**, daß das Testmuster in einem Codewort besteht, das aus einem Datenvektor mit frei wählbaren Datenbits und aus einem Redundanzvektor mit berechneten Redundanzbits zusammengesetzt ist, wobei der Redundanzvektor aus einer modulo 2 Matrizenmultiplikation zwischen einer durch einen fehlerkorrigierenden Code vorgegebenen Redundanzmatrix und dem Datenvektor ermittelt wird, daß das weitere Testmuster in einem weiteren Codewort besteht, das aus dem Einerkomplement des Codewortes gebildet wird, daß das erste und zweite Ergebnis einen ersten und zweiten Ergebnisvektor darstellt, wobei der erste bzw. zweite Ergebnisvektor aus einer modulo 2 Matrizenmultiplikation zwischen den ausgelesenen Informationen bzw. den ausgelesenen weiteren Informationen und einer durch den fehlerkorrigierenden Code vorgegebenen Prüfmatrix gebildet wird, daß der erste und zweite Ergebnisvektor zur Bestimmung der Fehleranzahl und zur Bestimmung der mit dem Fehler behafteten Speicherzellen innerhalb der Gruppe von Speicherzellen herangezogen wird.

2.  Verfahren nach Anspruch 1, **dadurch gekennzeichnet**, daß die ersten und zweiten Ergebnisvektoren für die übrigen Gruppen von Speicherzellen ermittelt werden und zur Bestimmung der Fehleranzahl und zur Bestimmung der mit den Fehler behafteten Speicherzellen innerhalb der übrigen Gruppen von Speicherzellen herangezogen werden.

3.  Verfahren nach Anspruch 1 oder 2, **dadurch gekennzeichnet**, daß der erste und zweite Ergebnisvektor aus einem Fehlerbit für gerade und ungerade Anzahl von Fehlern und Bits zur Einzelfehleradresse aufgebaut ist, daß der erste und zweite Ergebnisvektor in einer Gruppe von Speicherzellen zur Bestimmung der Fehleranzahl und zur Bestimmung der mit einem Fehler behafteten Speicherzelle innerhalb der Gruppen von Speicherzellen so herangezogen wird, daß alle Speicherzellen innerhalb der Gruppe funktionsfähig sind, falls der erste und zweite Ergebnisvektor Null ist, daß eine Speicherzelle innerhalb der Gruppe funktionsunfähig ist, falls einer der beiden Ergebnisvektoren Null und ein anderer der beiden Ergebnisvektoren einen Fehler anzeigt, daß die Adresse der funktionsunfähigen Speicherzelle innerhalb der Gruppe durch die Bits der Einzelfehleradresse im anderen der beiden Ergebnisvektoren angegeben ist, daß genau zwei Speicherzellen innerhalb der Gruppe funktionsunfähig sind, falls ein Ergebnisvektor gleich Null und der weitere Ergebnisvektor zwei Fehler anzeigt, daß zwei oder mehr Speicherzellen innerhalb der Gruppe funktionsunfähig sind, falls der erste und zweite Ergebnisvektor einen Fehler anzeigt und daß für alle übrigen Bitkombinationen der Ergebnisvektoren mehr als zwei Speicherzellen innerhalb der Gruppe funktionsunfähig sind.

4. Verfahren nach Anspruch 3, **dadurch gekennzeichnet**, daß das Codewort mit Hilfe des Hammingcode gebildet wird, daß einer der beiden Ergebnisvektoren eine ungeradzahlige Anzahl von Fehlern anzeigt falls ein erstes Bit desselbigen ungleich Null ist, und daß einer der beiden Ergebnisvektoren eine geradzahlige Anzahl von Fehlern anzeigt, falls ein erstes Bit desselbigen gleich Null und die übrigen Bit desselbigen ungleich Null sind.

5. Verfahren nach einem der Ansprüche 1 bis 4, **dadurch gekennzeichnet**, daß eine Gruppe von Speicherzellen aus 4 x 4 Bitworten besteht und die aus den Speicherzellen ausgelesenen Informationen als 4 x 4 Bitworte der Paralleltestvorrichtung zugeführt werden, die eine Breite von 16 Bit aufweist und daß das Codewort ein 11 Bit breiten Datenvektor und einen 5 Bit breiten Redundanzvektor enthält.

6. Vorrichtung zur Durchführung des Verfahrens nach einem der Ansprüche 1 bis 5, **dadurch gekennzeichnet**, daß die Paralleltestvorrichtung aus einer durch die Zeilenanzahl der Prüfmatrix vorgegebenen Anzahl von Paritätsprüfschaltungen besteht und jede Zeile der Prüfmatrix einer Paritätsprüfschaltung zugeordnet ist, daß die Bildung der modulo 2 Matrizenmultiplikation zwischen den aus den Speicherzellen der Gruppe ausgelesenen Informationen und der Prüfmatrix so realisiert ist, daß je ein Eingang der einer Zeile der Prüfmatrix zugehörigen Paritätsprüfschaltung je ein Ausgang der Speicherzellen einer Gruppe zugeordnet ist und genau dann miteinander verbunden wird, falls die betreffende Spalte der Zeile der Prüfmatrix eine "1" aufweist und genau dann miteinander nicht verbunden wird, falls die betreffende Spalte der Zeile der Prüfmatrix eine "0" aufweist, und daß am Ausgang einer jeden Paritätsprüfschaltung ein Element des Ergebnisvektors abgegriffen werden kann.

7. Vorrichtung nach Anspruch 6, **dadurch gekennzeichnet**, daß mindestens eine der Paritätsprüfschaltungen aus kaskadierten Paritätsprüfmodulen baumförmig aufgebaut ist.

8. Vorrichtung nach Anspruch 6 oder 7, **dadurch gekennzeichnet**, daß die Paralleltestvorrichtung eine Breite von 16 Bit für die ausgelesenen Informationen aus den Speicherzellen der Gruppe aufweist und jeweils das erste, zweite und dritte Element des Ergebnisvektors (E1, E2, E3) an jeweils einer ersten, zweiten und dritten Paritätsprüfschaltung abgegriffen werden kann, daß jede Paritätsprüfschaltung aus fünf Paritätsprüfmodulen aufgebaut ist, wobei jeweils die ersten vier Paritätsprüfmodule mit Ausgängen auf Eingänge des fünften Paritätsprüfmoduls geschaltet sind und der Ausgang des fünften Paritätsprüfmoduls jeweils einen Ausgang der Paritätsprüfschaltung bildet, daß das erste Paritätsprüfmodul (PM1) der ersten Paritätsprüfschaltung Eingänge für die Bits 1 bis 4 (B1 ... B4) der 16 Bit ausgelesenen Informationen der Speicherzelle der Gruppe, das zweite Paritätsprüfmodul (PM2) der ersten Paritätsprüfschaltung Eingänge für die Bits 5 bis 8 (B5...B8) der 16 Bit ausgelesenen Informationen der Speicherzellen der Gruppe, das dritte Paritätsprüfmodul (PM3) der ersten Paritätsprüfschaltung Eingänge für die Bits 9 bis 12 (B9...B12) der 16 Bit ausgelesenen Informationen der Speicherzellen der Gruppe und das vierte Paritätsprüfmodul (PM4) der ersten Paritätsprüfschaltung Eingänge für die Bits 13 bis 16 (B13...B16) der 16 Bit ausgelesenen Informationen der Speicherzellen der Gruppe aufweist, daß jeweils der erste und dritte Eingang des ersten, zweiten, dritten und vierten Paritätsprüfmoduls (PM6, PM7, PM8, PM9) der zweiten Paritätsprüfschaltung auf einen festen Spannungswert gelegt ist und der zweite Eingang des ersten Paritätsprüfmoduls (PM6) der zweiten Paritätsprüfschaltung mit Bit 2 (B2) und der vierte Eingang desselbigen mit Bit 4 (B4) der ausgelesenen Informationen beschaltet ist, daß der zweite Eingang des zweiten Paritätsprüfmoduls (PM7) der zweiten Paritätsprüfschaltung mit Bit 6 (B6) und der vierte Eingang desselbigen mit Bit 8 (B8) der ausgelesenen Informationen verbunden ist, daß der zweite Eingang des dritten Paritätsprüfmoduls (PM8) der zweiten Paritätsprüfschaltung mit Bit 10 (B10) und der vierte Eingang desselbigen mit Bit 12 (B12) der ausgelesenen Informationen angeschlossen ist, daß der zweite Eingang des vierten Paritätsprüfmoduls der zweiten Paritätsprüfschaltung mit Bit 14 (B14) und der vierte Eingang desselbigen mit Bit 16 (B16) der angeschlossenen Informationen verschaltet ist, daß jeweils der erste und zweite Eingang des ersten, zweiten, dritten und vierten Paritätsprüfmoduls (PM11, PM12, PM13, PM14) der dritten Paritätsprüfschaltung auf einen festen Spannungswert gelegt ist und der dritte Eingang des ersten Paritätsprüfmoduls (PM11) der dritten Paritätsprüfschaltung mit Bit 3 (B3) und der vierte Eingang desselbigen mit Bit 4 (B4) der ausgelesenen Informationen verbunden ist, daß der dritte Eingang des zweiten Paritätsprüfmoduls (PM12) der dritten Paritätsprüfschaltung mit Bit 7 (B7) und der vierte Eingang desselbigen mit Bit 8 (B8) der ausgelesenen informationen zu verbinden ist, daß der dritte Eingang des dritten Paritätsprüfmoduls PM13 der dritten Paritätsprüfschaltung mit Bit 11 (B11) und der vierte Eingang desselbigen mit Bit 12 (B12) der auszulesenden Informationen verschaltet ist, daß der dritte Eingang des vierten Paritätsprüfmoduls (PM 14) mit Bit 15 (B15), und der vierte Eingang desselbigen mit Bit 16 (B16) der auszulesenden Informationen zu verschalten ist, daß das Element des vierten und fünften Ergebnisvektors jeweils an einen Ausgang eines XOR-Gatters abgegriffen werden kann, wobei ein erster Eingang des einen XOR-Gatters (XOR1) für das vierte Element (E4) des Ergebnisvektors mit dem Ausgang (A2) des zweiten Paritätsprüfmoduls (PM2) der ersten Paritätsprüfschaltung und ein zweiter Eingang desselbigen XOR-Gatters (XOR1) mit einem Ausgang (A4) des vierten Paritätsprüfmoduls (PM4) der ersten Paritätsprüfschaltung verschaltet ist, und daß ein erster Eingang des anderen XOR-Gatters (XOR2) für das fünfte Element (E5) des Ergebnisvektors mit einem Ausgang (A3) des dritten Paritätsprüfmoduls (PM3) der ersten Paritätsprüfschaltung und ein zweiter Eingang desselben XOR-Gatters (XOR2) mit einem Ausgang des vierten Paritätsprüfmoduls (PM4) der ersten Paritätsprüfschaltung verbunden ist.

9.  Vorrichtung nach Anspruch 6, **dadurch gekennzeichnet**, daß die Paralleltestvorrichtung ein Breite von 16 Bit für die ausgelesenen Informationen aus den Speicherzellen der Gruppe aufweist und jeweils das erste, zweite und dritte Element des Ergebnisvektors (E1, E2, E3) an jeweils einem ersten, zweiten und dritten Paritätsprüfmodul (PM5, PM10, PM15) abgegriffen werden kann, daß dem ersten, zweiten und dritten Paritätsprüfmodul vier je gleich aufgebaute Logikschaltungen vorgeschaltet sind, daß jede Logikschaltung einen ersten, zweiten, dritten und vierten Eingang und einen ersten, zweiten und dritten Ausgang aufweist, daß jeweils Bit 1 bis 4 (B1... B4) der 16 Bit ausgelesenen Informationen der Speicherzelle der Gruppe auf jeweils den ersten, zweiten, dritten und vierten Eingang der ersten Logikschaltung, jeweils Bit 5 bis 8 (B5... B8) der 16 Bit ausgelesenen Informationen der Speicherzelle der Gruppe auf jeweils den ersten, zweiten, dritten und vierten Eingang der zweiten Logikschaltung, jeweils Bit 9 bis 12 (B9...B12) der 16 Bit ausgelesenen Informationen der Speicherzelle einer Gruppe auf jeweils den ersten, zweiten, dritten und vierten Eingang der dritten Logikschaltung und jeweils Bit 13 bis 16 (B13...B16) der 16 Bit ausgelesenen Informationen der Speicherzelle einer Gruppe auf jeweils den ersten, zweiten, dritten und vierten Eingang der vierten Logikschaltung geschaltet ist, daß der erste Ausgang jeweils der ersten, zweiten, dritten und vierten Logikschaltung auf das erste Paritätsprüfmodul (PM5), der zweite Ausgang jeweils der ersten, zweiten, dritten und vierten Logikschaltung auf das zweite Paritätsprüfmodul (PM10) und der dritte Ausgang jeweils der ersten, zweiten, dritten und vierten Logikschaltung auf das dritte Paritätsprüfmodul aufgeschaltet ist, daß das Element des vierten und fünften Ergebnisvektors (E4, E5) jeweils an einen Ausgang eines XOR-Gatters abgegriffen werden kann, wobei ein erster Eingang des einen XOR-Gatters (XOR1) für das vierte Element (E4) des Ergebnisvektors mit dem ersten Ausgang der zweiten Logikschaltung und ein zweiter Eingang desselbigen XOR-Gatters (XOR1) mit dem ersten Ausgang der vierten Logikschaltung verbunden ist, und daß ein erster Eingang des anderen XOR-Gatters (XOR2) für das fünfte Element (E5) des Ergebnisvektors mit dem ersten Ausgang der dritten Logikschaltung und ein zweiter Eingang desselben XOR-Gatters (XOR2) mit dem ersten Ausgang der vierten Logikschaltung verbunden ist.

10. Vorrichtung nach Anspruch 9, **dadurch gekennzeichnet**, daß eine Logikschaltung vier XOR-Gatter (XOR3, XOR4, XOR5, XOR6) enthält, wobei ein erstes XOR-Gatter (XOR3) einer Logikschaltung mit einem ersten und zweiten Eingang jeweils den ersten und zweiten Eingang einer Logikschaltung und ein zweites XOR-Gatter (XOR4) einer Logikschaltung mit einem ersten und zweiten Eingang jeweils den dritten und vierten Eingang einer Logikschaltung darstellt, daß ein drittes XOR-Gatter (XOR5) jeweils mit dem zweiten Eingang des ersten und zweiten XOR-Gatters (XOR3, XOR4) einer Logikschaltung verbunden ist, daß jeweils ein Ausgang des ersten und zweiten XOR-Gatters (XOR3, XOR4) einer Logikschaltung auf jeweils einen Eingang eines vierten XOR-Gatters (XOR6) einer Logikschaltung geschaltet ist und ein Ausgang dieses vierten XOR-Gatters (XOR6) den ersten Ausgang einer Logikschaltung bildet, daß ein Ausgang des dritten XOR-Gatters (XOR5) einer Logikschaltung den zweiten Ausgang einer Logikschaltung und ein Ausgang des zweiten XOR-Gatters (XOR4) einer Logikschaltung den dritten Ausgang einer Logikschaltung darstellt.

11. Vorrichtung nach einem der Ansprüche 8 bis 10, **dadurch gekennzeichnet**, daß das andere XOR-Gatter (XOR2) für das fünfte Element (E5) des Ergebnisvektors Teil des fünften Paritätsprüfmoduls (PM5) der ersten Paritätsprüfschaltung ist.

12. Vorrichtung nach einem der Ansprüche 6 bis 11, **dadurch gekennzeichnet, daß die Paritätsprüfmodule aus je einem ersten, zweiten und dritten XOR-Gatter aufgebaut werden, wobei die XOR-Gatter zwei Eingänge und einen Ausgang aufweisen und der Ausgang des ersten XOR-Gatters (XOR1') auf einen ersten Eingang des dritten XOR-Gatters (XOR3') und der Ausgang des zweiten XOR-Gatters (XOR2') auf einen

13

zweiten Eingang des dritten XOR-Gatters (XOR3') geschaltet ist, daß ein erster und zweiter Eingang (E1, E2) des ersten XOR-Gatters (XOR1') und ein erster und zweiter Eingang (E3, E4) des zweiten XOR-Gatters die Eingänge des Paritätsprüfmoduls und ein Ausgang des dritten XOR-Gatters (XOR3') den Ausgang (A) desselbigen bildet.

13. Vorrichtung nach einem der Ansprüche 6 bis 11, **dadurch gekennzeichnet**, daß die Paritätsprüfmodule aus je vier verketteten push-pull-Stufen aufgebaut sind, und zwei verkettete Push-Pull-Stufen dabei eine XOR Funktion bilden, wobei jede Push-Pull-Stufe einen ersten und zweiten Spannungseingang, einen ersten und zweiten Spannungsausgang und einen ersten und zweiten Dateneingang enthalten, und der erste Spannungseingang der ersten Push-Pull-Stufe mit einer ersten Spannung ($V_{DD}$) und der zweite Spannungseingang der ersten Push-Pull-Stufe mit einer zweiten Spannung ($V_{SS}$) verschaltet ist, daß der erste und zweite Spannungsausgang der vierten Push-Pull-Stufe einen ersten und zweiten jeweils komplementären Ausgang des Paritätsprüfmoduls (OUT, OUTQ) bildet, daß die Push-Pull-Stufen so verkettet sind, daß jeweils ein erster und zweiter Spannungsausgang der einen Push-Pull-Stufe mit jeweils einem ersten und zweiten Spannungseingang der anderen Push-Pull-Stufe verschaltet ist, und daß jeweils der erste und zweite zueinander komplementäre Dateneingang (IN1, IN2, IN3, IN4; INQ1, INQ2, INQ3, INQ4) der vier Push-Pull-Stufen Eingänge des Paritätsprüfmoduls darstellen.

14. Vorrichtung nach Anspruch 13, **dadurch gekennzeichnet**, daß eine Push-Pull-Stufe aus vier Feldeffekttransistoren gleichen Leitungstyps ausgebaut sind, wobei ein erster und zweiter Feldeffekttransistor (T1, T2) eine erste Serienschaltung und ein dritter und vierter Feldeffekttransistor (T3, T4) eine zweite Serienschaltung bilden, daß die erste und zweite Serienschaltung parallel geschaltet sind wobei ein Anschluß des ersten Feldeffekttransistors (T1) und ein Anschluß des vierten Feldeffekttransistors (T4) einen ersten gemeinsamen Anschluß und ein Anschluß des zweiten Feldeffekttransistors (T2) und ein Anschluß des dritten Feldeffekttransistors (T3) einen zweiten gemeinsamen Anschluß bilden, daß der erste gemeinsame Anschluß einen ersten Spannungseingang und der zweite gereinsame Anschluß einen zweiten Spannungseingang bilden, daß ein Mittenanschluß der ersten Serienschaltung einen ersten Spannungsausgang und ein Mittenanschluß der zweiten Serienschaltung einen zweiten Spannungsausgang einer Push-Pull-Stufe darstellen, daß ein Gateanschluß des ersten und ein Gateanschluß des dritten Feldeffekttransistors (T1, T3) gemeinsamen einen ersten Dateneingang (IN1) und ein Gateanschluß des zweiten Feldeffekttransistors (T2) und ein Gateanschluß des vierten Feldeffekttransistors (T4) gemeinsam einen zweiten Dateneingang (INQ1) bilden.

15. Vorrichtung nach Anspruch 14, **dadurch gekennzeichnet**, daß die Feldeffekttransistoren der Push-Pull-Stufen n-Kanal-Feldeffekttransistoren sind und der feste Spannungswert durch das Bezugspotential Masse gebildet wird.

16. Vorrichtung nach Anspruch 14, **dadurch gekennzeichnet**, daß die Feldeffekttransistoren der Push-Pull-Stufen p-Kanal-Feldeffekttransistoren sind und der feste Spannungswert durch die Betriebsspannung gebildet wird.

## Claims

1. Method for the parallel testing of memory cells of a memory, the memory being divided into groups of memory cells, and one group of memory cells being activated by addressing word lines and/or bit lines in the memory, in the case of which a test pattern is in each case written into all the memory cells in a group, and in each case all the memory cells in the group are subsequently read from and the information read out is supplied to a parallel testing device, as a result of which a first result is determined, in the case of which a further test pattern is formed from the test pattern and the further test pattern is written into all the memory cells of the same group and is subsequently read out of all the memory cells in the same group again, and the further information read out is supplied to the parallel testing device, as a result of which a second result is determined, characterized in that the test pattern comprises a code word which is composed of a data vector with freely selectable data bits and of a redundancy vector with calculated redundancy bits, the redundancy vector being determined from a modulo 2 matrix multiplication between a redundancy matrix, which is specified by an error-correcting code, and the data vector, in that the further test pattern comprises a further code word which is formed from the 1's complement of the code word, in that the first and the second result represent a first and a second result vector, the first and the second result vector being formed from a modulo 2 matrix multiplication between the information read out and the further information read out and a test matrix which is specified by the error-correcting code, in that the first and the second result vector are used to determine the number of errors and to determine those memory cells which are subject to the error within the group of memory cells.

2. Method according to Claim 1, characterized in that the first and the second result vectors are determined for the other groups of memory cells and are used for determining the number of errors and for determining those memory cells which are subject to the error within the other groups of memory cells.

3. Method according to Claim 1 or 2, characterized in that the first and the second result vector are formed from an error bit for an even number and odd number of errors and bits for the individual error address, in that the first and the second result vector in a group of memory cells are used to determine the number of errors and to determine that memory cell which is subject to an error within the groups of memory cells, such that all the memory cells within the group are serviceable if the first and the second result vector are zero, in that a memory cell within the group is unserviceable if one of the two result vectors is zero and another of the two result vectors indicates an error, in that the address of the unserviceable memory cell within the group is indicated by the bits of the individual error address in the other of the two result vectors, in that precisely two memory cells within the group are unserviceable if one result vector is equal to zero and the other result vector indicates two errors, in that two or more memory cells within the group are unserviceable if the first and the second result vector indicates an error, and in that more than two memory cells within the group are unserviceable for all other bit combinations of the result vectors.

4. Method according to Claim 3, characterized in that the code word is formed with the aid of the Hamming code, in that one of the two result vectors indicates an odd number of errors if a first bit in the same is not equal to zero, and in that one of the two result vectors indicates an even number of errors if a first bit in the same is equal to zero and the other bit in the same is not equal to zero.

5. Method according to one of Claims 1 to 4, characterized in that a group of memory cells comprises $4 \times 4$ bit words and the information read out of the memory cells is supplied as $4 \times 4$ bit words to the parallel testing device, which has a length of 16 bits, and in that the code word contains an 11-bit long data vector and a 5-bit long redundancy vector.

6. Device for carrying out the method according to one of Claims 1 to 5, characterized in that the parallel testing device comprises a number of parity test circuits, the number of which is predetermined by the number of rows in the test matrix, and each row of the test matrix is assigned a parity test circuit, in that the formation of the modulo 2 matrix multiplication between the information read out of the memory cells in the group and the test matrix is implemented such that in each case one input of the parity test circuit belonging to one row of the test matrix is assigned to in each case one output of the memory cells in a group and they are connected to one another strictly if the relevant column in the row of the test matrix has a "1" and are strictly not connected to one another if the relevant column in the row of the test matrix has a "0", and in that an element of the result vector can be picked off at the output of each parity test circuit.

7. Device according to Claim 6, characterized in that at least one of the parity test circuits is constructed in the form of a tree from cascaded parity test modules.

8. Device according to Claim 6 or 7, characterized in that the parallel testing device has a length of 16 bits for the information read out of the memory cells in the group, and the first, second and third elements of the result vector (E1, E2, E3) can in each case be picked off from a first, second and third parity test circuit in each case, in that each parity test circuit is constructed from five parity test modules, the first four parity test modules in each case being connected by outputs to inputs of the fifth parity test module, and the output of the fifth parity test module in each case forming an output of the parity test circuit, in that the first parity test module (PM1) of the first parity test circuit has inputs for the bits 1 to 4 (B1 ... B4) of the 16 bits of information read out of the memory cell in the group, the second parity test module (PM2) of the first parity test circuit has inputs for the bits 5 to 8 (B5...B8) of the 16 bits of information read out of the memory cells in the group, the third parity test module (PM3) of the first parity test circuit has inputs for the bits 9 to 12 (B9...B12) of the 16 bits of information read out of the memory cells in the group, and the fourth parity test module (PM4) of the first parity test circuit has inputs for the bits 13 to 16 (B13...B16) of the 16 bits of information read out of the memory cells in the group, in that the first and the third input in each case of the first, second, third and fourth parity test modules (PM6, PM7, PM8, PM9) of the second parity test circuit are connected to a fixed voltage level, and the second input of the first parity test module (PM6) of the second parity test circuit is connected to bit 2 (B2) of the information read out, and the fourth input of the same is connected to bit 4 (B4) of the information read out, in that the second input of the second parity test module (PM7) of the second parity test circuit is connected to bit 6 (B6) of the information read out, and the fourth input of the same is connected to bit 8 (B8) of the information read out, in that the second input of the third parity test module (PM8) of the second parity test circuit is connected with bit 10 (B10) of the information read out, and the fourth input of the same is connected with bit 12 (B12) of the information read out, in that the second input of the fourth parity test module of the second parity test circuit is connected to bit 14 (B14) of the connected information, and the fourth input of the same is connected to bit 16 (B16) of the connected information, in that the first and the second input in each case of the first, second, third and fourth parity test modules (PM11, PM12, PM13, PM14) of the third parity test circuit are connected to a fixed voltage level, and the third input of the first parity test module (PM11) of the third parity test circuit is connected to bit 3 (B3) of the information read out, and the fourth input of the same is connected to bit 4 (B4) of the information read out, in that the third input of the second parity test module (PM12) of the third parity test circuit is connected to bit 7 (B7) of the information read out, and the fourth input of the same is connected to bit 8 (B8) of the information read out, in that the third input of the third parity test module (PM13) of the third parity test circuit is connected to bit 11 (B11) of the information to be read out and the fourth input of the same is connected to bit 12 (B12) of the information to be read out, in that the third input of the fourth parity test module (PM14) is to be connected to bit 15 (B15) of the information to be read out, and the fourth input of the same is to be connected to bit 16 (B16) of the information to be read out, in that the elements of the fourth and of the fifth result vector can in each case be picked off at an output of an XOR gate, a first input of one XOR gate (XOR1) for the fourth element (E4) of the result vector being connected to the output (A2) of the second parity test module (PM2) of the first parity test circuit, and a second input of the same XOR gate (XOR1) being connected to an output (A4) of the fourth parity test module (PM4) of the first parity test circuit, and in that a first input of the other XOR gate (XOR2) for the fifth element (E5) of the result vector is connected to an output (A3) of the third parity test module (PM3) of the first parity test circuit, and a second input of the same XOR gate (XOR2) is connected to an output of the fourth parity test module (PM4) of the first parity test circuit.

9. Device according to Claim 6, characterized in that the parallel testing device has a length of 16 bits for the information read out of the memory cells in the group, and the first, second and third elements of the result vector (E1, E2, E3) can in each case be picked off on a first, second and third parity test module (PM5, PM10, PM15) in each case, in that four logic circuits, which are each of identical construction, are connected upstream of the first, second and third parity test modules, in that each logic circuit has a first, a second, a third and a fourth input and a first, a second and a third ouput, in that bits 1 to 4 (B1...B4) respectively of the 16 bits of information read out of the memory cell in the group are connected in each case to the first, the second, the third and the fourth input of the first logic circuit, bits 5 to 8 (B5...B8) respectively of the 16 bits of information read out of the memory cell in the group are connected in each case to the first, the second, the third and the fourth input of the second logic circuit, bits 9 to 12 (B9...B12) respectively of the 16 bits of information read out of the memory cell in a group are connected in each case to the first, the second, the third and the fourth input of the third logic circuit, and bits 13 to 16 (B13...B16) respectively of the 16 bits of information read out of the memory cell in a group are connected in each case to the first, the second, the third and the fourth input of the fourth logic circuit, in that the first output in each case of the first, the second, the third and the fourth logic circuit is connected to the first parity test module (PM5), the second output in each case of the first, the second, the third and the fourth logic circuit is connected to the second parity test module (PM10), and the third output in each case of the first, the second, the third and the fourth logic circuit is connected to the third parity test module, in that the element of the fourth and the fifth result vector (E4, E5) can in each case be picked off at an output of an XOR gate, a first input of one XOR gate (XOR1) for the fourth element (E4) of the result vector being connected to the first output of the second logic circuit, and a second input of the same XOR gate (XOR1) being connected to the first output of the fourth logic circuit, and in that a first input of the other XOR gate (XOR2) for the fifth element (E5) of the result vector is connected to the first output of the third logic circuit, and a second input of the same XOR gate (XOR2) is connected to the first output of the fourth logic circuit.

10. Device according to Claim 9, characterized in that a logic circuit contains four XOR gates (XOR3, XOR4,

16

EP 0 400 179 B1

XOR5, XOR6), a first XOR gate (XOR3) of a logic circuit having a first and a second input in each case representing the first and the second input of a logic circuit, and a second XOR gate (XOR4) of a logic circuit having a first and a second input in each case representing the third and the fourth input of a logic circuit, in that a third XOR gate (XOR5) is in each case connected to the second input of the first and the second XOR gate (XOR3, XOR4) of a logic circuit, in that in each case one output of the first and the second XOR gate (XOR3, XOR4) of a logic circuit is connected to in each case one input of a fourth XOR gate (XOR6) of a logic circuit, and an output of this fourth XOR gate (XOR6) forms the first output of a logic circuit, in that an output of the third XOR gate (XOR5) of a logic circuit represents the second output of a logic circuit, and an output of the second XOR gate (XOR4) of a logic circuit represents the third output of a logic circuit.

11. Device according to one of Claims 8 to 10, characterized in that the other XOR gate (XOR2) for the fifth element (E5) of the result vector is part of the fifth parity test module (PM5) of the first parity test circuit.

12. Device according to one of Claims 6 to 11, characterized in that the parity test modules are in each case constructed from a first, a second and a third XOR gate, the XOR gates having two inputs and one output, and the output of the first XOR gate (XOR1') being connected to a first input of the third XOR gate (XOR3'), and the output of the second XOR gate (XOR2') being connected to a second input of the third XOR gate (XOR3'), in that a first and a second input (E1, E2) of the first XOR gate (XOR1') and a first and a second input (E3, E4) of the second XOR gate form the inputs of the parity test module, and an output of the third XOR gate (XOR3') forms the output (A) of the same.

13. Device according to one of Claims 6 to 11, characterized in that the parity test modules are constructed from in each case four interlinked push-pull stages, and two interlinked push-pull stages at the same time form an XOR function, each push-pull stage containing a first and a second voltage input, a first and a second voltage output and a first and a second data input, and the first voltage input of the first push-pull stage being connected to a first voltage ($V_{DD}$), and the second voltage input of the first push-pull stage being connected to a second voltage ($V_{SS}$), in that the first and the second voltage output of the fourth push-pull stage form a first and a second respectively complementary output of the parity test module (OUT, OUTQ), in that the push-pull stages are interlinked such that a first and a second voltage output in each case of the one push-pull stage is connected in each case to a first and a second voltage input of the other push-pull stage, and in that the first and the second mutually complementary data inputs (IN1, IN2, IN3, IN4; INQ1, INQ2, INQ3, INQ4) of the four push-pull stages in each case represent inputs of the parity test module.

14. Device according to Claim 13, characterized in that a push-pull stage is constructed from four field-effect transistors of the same conductance type, a first and a second field-effect transistor (T1, T2) forming a first series circuit, and a third and a fourth field-effect transistor (T3, T4) forming a second series circuit, in that the first and the second series circuit are connected in parallel, a connection of the first field-effect transistor (T1) and a connection of the fourth field-effect transistor (T4) forming a first common connection, and a connection of the second field-effect transistor (T2) and a connection of the third field-effect transistor (T3) forming a second common connection, in that the first common connection forms a first voltage input and the second common connection forms a second voltage input, in that a centre connection of the first series circuit represents a first voltage output, and a centre connection of the second series circuit represents a second voltage output of a push-pull stage, in that a gate connection of the first field-effect transistor (T1) and a gate connection of the third field-effect transistor (T3) jointly form a first data input (IN1), and a gate connection of the second field-effect transistor (T2) and a gate connection of the fourth field-effect transistor (T4) jointly form a second data input (INQ1).

15. Device according to Claim 14, characterized in that the field-effect transistors of the push-pull stages are n-channel field-effect transistors, and the fixed voltage value is formed by the reference potential earth.

16. Device according to Claim 14, characterized in that the field-effect transistors of the push-pull stages are p-channel field-effect transistors, and the fixed voltage value is formed by the operating voltage.

## Revendications

1. Procédé de test en parallèle de cellules d'une mémoire, selon lequel on divise la mémoire en groupes de

17

cellules de mémoire, et on active un groupe de cellules de mémoire par adressage de lignes de transmission de mots et/ou de transmission de bits de la mémoire, selon lequel on enregistre un motif de test respectivement dans toutes les cellules de mémoire du groupe, on lit ensuite toutes les cellules de mémoire du groupe, on envoie les informations lues à un dispositif de test en parallèle, ce qui permet de déterminer un premier résultat, selon lequel on forme un autre motif de test à partir du premier motif de test, on enregistre l'autre motif de test dans toutes les cellules de mémoire du même groupe et on le lit ensuite à nouveau à partir de toutes les cellules de mémoire du même groupe, on envoie les autres informations lues au dispositif de test en parallèle, ce qui détermine un second résultat, caractérisé par le fait que le motif de test est constitué d'un mot de code, qui se compose d'un vecteur de données ayant des bits de données pouvant être librement choisis et d'un vecteur de redondance comportant des bits de redondance calculés, le vecteur de redondance étant déterminé au moyen d'une multiplication matricielle modulo 2 entre une matrice de redondance prédéterminée par un code de correction d'erreurs et un vecteur de données, que l'autre motif de test est constitué d'un autre mot de code, qui est formé du complément à un du mot de code, que les premier et second résultats représentent des premier et second vecteurs de résultat, le premier et le second vecteurs de résultat étant formés par une multiplication matricielle modulo 2 entre les informations lues ou les autres informations lues et une matrice de contrôle prédéterminée par le code de correction d'erreurs et on utilise les premier et second vecteurs de résultat pour la détermination du nombre d'erreurs et pour la détermination des cellules de mémoire, affectées de l'erreur, à l'intérieur du groupe de cellules de mémoire.

2. Procédé suivant la revendication 1, caractérisé par le fait que l'on détermine les premier et second vecteurs de résultat pour les autres groupes de cellules de mémoire et on les utilise pour la détermination du nombre d'erreurs et pour la détermination des cellules de mémoire, qui sont affectées d'erreurs, à l'intérieur des autres groupes de cellules de mémoire.

3. Procédé suivant la revendication 1 ou 2, caractérisé par le fait que les premier et second vecteurs de résultat sont constitués d'un bit d'erreur pour un nombre pair et un nombre impair d'erreurs et de bits pour l'adresse d'erreur individuelle, que l'on utilise les premier et second vecteurs de résultat dans un groupe de cellules de mémoire pour la détermination du nombre d'erreurs et pour la détermination de la cellule de mémoire, affectée d'une erreur, à l'intérieur du groupe de cellules de mémoire, de sorte que toutes les cellules de mémoire à l'intérieur d'un groupe soient aptes à fonctionner dans le cas où les premier et second vecteurs de résultat sont nuls, qu'une cellule de mémoire soit inapte à fonctionner à l'intérieur d'un groupe, dans le cas où l'un des deux vecteurs de résultat est nul et où un autre des deux vecteurs de résultat indique une erreur, que l'adresse de la cellule de mémoire inapte à fonctionner à l'intérieur du groupe est indiquée par les bits de l'adresse de l'erreur individuelle dans l'autre des deux vecteurs de résultat, que précisément deux cellules de mémoire à l'intérieur du groupe sont inaptes à fonctionner, dans le cas où un vecteur de résultat est nul et où l'autre vecteur de résultat indique deux erreurs, que deux ou un plus grand nombre de cellules de mémoire à l'intérieur du groupe sont inaptes à fonctionner, dans le cas où les premier et second vecteurs d'erreurs indiquent une erreur, et que pour toutes les autres combinaisons de bits des vecteurs de résultat, plus de deux cellules de mémoire à l'intérieur du groupe sont inaptes à fonctionner.

4. Procédé suivant la revendication 3, caractérisé par le fait que l'on forme le mot de code à l'aide du code de Hamming, que l'un des deux vecteurs de résultat indique un nombre impair d'erreurs dans le cas où un premier bit de ce vecteur n'est pas égal à zéro et que l'un des deux vecteurs de résultat indique un nombre pair d'erreurs dans le cas où un premier bit de ce vecteur est égal à zéro et que les autres bits de ce vecteur ne sont pas égaux à zéro.

5. Procédé suivant l'une des revendications 1 à 4, caractérisé par le fait qu'un groupe de cellules de mémoire est constitué de mots à 4 x 4 bits et que l'on envoie les informations lues à partir des cellules de mémoire sous la forme de mots à 4 x 4 bits au dispositif de test en parallèle, qui a une largeur de 16 bits et que le mot de code contient un vecteur de données d'une largeur de 11 bits et un vecteur de redondance d'une largeur de 5 bits.

6. Dispositif pour la mise en oeuvre du procédé suivant l'une des revendications 1 à 5, **caractérisé par le** fait que le dispositif de test en parallèle est constitué d'un nombre de circuits de contrôle de parité, qui est prédéterminé par le nombre des lignes de la matrice de contrôle, et que chaque ligne de la matrice de contrôle est associée à un circuit de contrôle de parité, que la formation de la multiplication matricielle modulo 2 entre les informations lues à partir des cellules de mémoire du groupe et la matrice de contrôle s'effectue de telle sorte que chaque entrée du circuit de contrôle de parité associée à une ligne de contrôle est associée à une sortie des cellules de mémoire d'un groupe et que cette entrée et cette sortie sont précisément reliées entre elles dans le cas où la colonne considérée de la ligne de la matrice de contrôle comporte un "1", et ne sont pas reliées entre elles précisément dans le cas où la colonne considérée de la ligne de la matrice de contrôle comporte un "0", et qu'un élément du vecteur de résultat peut être prélevé sur la sortie de chaque circuit de contrôle de parité.

7. Dispositif suivant la revendication 6, caractérisé par le fait qu'au moins l'un des circuits de contrôle de parité est constitué, sous la forme d'un arbre, de modules de contrôle de parité en cascade.

8. Dispositif suivant la revendication 6 ou 7, caractérisé par le fait que le dispositif de test en parallèle a une largeur de 16 bits pour les informations lues à partir des cellules de mémoire du groupe et que les premier, second et troisième éléments du vecteur de résultat (E1, E2, E3) peuvent être prélevés respectivement de premier, second et troisième circuits de contrôle de parité, que chaque circuit de contrôle de parité est constitué de cinq modules de contrôle de parité, parmi lesquels les quatre premiers modules de contrôle de parité sont raccordés, par des sorties, à des entrées du cinquième module de contrôle de parité et la sortie du cinquième module de contrôle de parité forme une sortie du circuit de contrôle de parité, que le premier module de contrôle de parité (PM1) du premier circuit de contrôle de parité comporte des entrées pour les bits 1 à 4 (B1...B4) des informations lues à 16 bits de la cellule de mémoire du groupe, que le second module de contrôle de parité (PM2) du premier circuit de contrôle de parité comporte des entrées pour les bits 5 à 8 (B5...B8) des informations lues à 16 bits des cellules de mémoire du groupe, que le troisième module de contrôle de parité (PM3) du premier circuit de contrôle de parité comporte des entrées pour les bits 9 à 12 (B9...B12) des informations lues à 16 bits des cellules de mémoire du groupe et que le quatrième module de contrôle de parité (PM4) du premier circuit de contrôle de parité comporte des entrées pour les bits 13 à 16 (B13...B16) des informations lues à 16 bits des cellules de mémoire du groupe, que les première et troisième entrées des premier, second, troisième et quatrième modules de contrôle de parité (PM6, PM7, PM8, PM9) du second circuit de contrôle de parité sont placées à une valeur de tension fixe et que la seconde entrée du premier module de contrôle de parité (PM6) du second circuit de contrôle de parité est reliée au bit 2 (B2) et que la quatrième entrée de ce même module est reliée au bit 4 (B4) des informations lues, que la seconde entrée du second module de contrôle de parité (PM7) du second circuit de contrôle de parité est reliée au bit 6 (B6) et que la quatrième entrée de ce même module est reliée au bit 8 (B8) des informations lues, que la seconde entrée du troisième module de contrôle de parité (PM8) du second circuit de contrôle de parité est reliée au bit 10 (B10) et que la quatrième entrée de ce module est reliée au bit 12 (B12) des informations lues, que la seconde entrée du quatrième module de contrôle de parité du second circuit de contrôle de parité est reliée au bit 14 (B14) et que la quatrième entrée de ce module est reliée au bit 16 (B16) des informations appliquées, que respectivement les première et seconde entrées des premier, second, troisième et quatrième modules de contrôle de parité (PM11, PM12, PM13, PM14) du troisième circuit de contrôle de parité sont placées à une valeur de tension fixe et que la troisième entrée du premier module de contrôle de parité (PM11) du troisième circuit de contrôle de parité est reliée au bit 3 (B3) et que la quatrième entrée de ce module est reliée au bit 4 (B4) des informations lues, que la troisième entrée du second module de contrôle de parité (PM12) du troisième circuit de contrôle de parité est reliée au bit 7 (B7) et que la quatrième entrée de ce même module est reliée au bit 8 (B8) des informations lues, que la troisième entrée du troisième module de contrôle de parité (PM13) du troisième circuit de contrôle de parité est reliée au bit 11 (B11) et que la quatrième entrée de ce module est reliée au bit 12 (B12) des informations devant être lues, que la troisième entrée du quatrième module de contrôle de parité (PM14) est reliée au bit 15 (B15) et que la quatrième entrée de ce module est doit être reliée au bit 16 (B16) des informations devant être lues, que l'élément des quatrième et cinquième vecteurs de résultat peut être prélevé respectivement sur une sortie d'une porte OU-EXCLUSIF, une première entrée d'une première porte OU-EXCLUSIF (XOR1) pour le quatrième élément (E4) du vecteur de résultat étant raccordée à la sortie (A2) du second module de contrôle de parité (PM2) du premier circuit de contrôle de parité, tandis qu'une seconde entrée de cette même porte OU-EXCLUSIF (XORI) est reliée à une sortie (A4) du quatrième module de contrôle de parité (PM4) du premier circuit de contrôle de parité, et qu'une première entrée de l'autre porte OU-EXCLUSIF (XOR2) pour le cinquième élément (E5) du vecteur de résultat est raccordée à une sortie (A3) du troisième module de contrôle de parité (PM3) du premier circuit de contrôle de parité et qu'une seconde entrée de cette même porte OU-EXCLUSIF (XOR2) est reliée à une sortie du quatrième module de contrôle de parité (PM4) du premier circuit de contrôle de parité.

EP 0 400 179 B1

9. Dispositif suivant la revendication 6, caractérisé par le fait que le dispositif de test en parallèle a une largeur de 16 bits pour les informations lues à partir des cellules de mémoire du groupe et que les premier, second et troisième éléments du vecteur de résultat (E1,E2,E3) peuvent être prélevés dans des premier, second et troisième modules respectifs de contrôle de parité (PM5, PM10, PM15), que des circuits logiques de même constitution sont branchés en amont de chacun des premier et second modules de contrôle de parité, que chaque circuit logique comporte des première, seconde, troisième et quatrième entrées et des première, seconde et troisième sorties, que les bits 1 à 4 (B1...B4) des informations lues à 16 bits de la cellule de mémoire du groupe sont reliés respectivement aux première, seconde, troisième et quatrième entrées du premier circuit logique, que les bits 5 à 8 (B5...B8) des informations lues à 16 bits de la cellule de mémoire du groupe sont reliés respectivement aux première, seconde, troisième et quatrième entrées du second circuit logique, que les bits 9 à 12 (B9...B12) des informations lues à 16 bits de la cellule de mémoire d'un groupe sont reliés respectivement aux première, seconde, troisième et quatrième entrées du troisième circuit logique et les bits 13 à 16 (B13...B16) des informations lues à 16 bits de la cellule de mémoire d'un groupe sont reliés respectivement aux première, seconde, troisième et quatrième entrées du quatrième circuit logique, que la première sortie des premier, second, troisième et quatrième circuits logiques est raccordée au premier module de contrôle de parité (PM5), la seconde sortie des premier, second, troisième et quatrième circuits logiques est raccordée au second module de contrôle de parité (PM10), et la troisième sortie des premier, second, troisième et quatrième circuits logiques est raccordée au troisième module de contrôle de parité, que l'élément des quatrième et cinquième vecteurs de résultat (E4, E5) peut être prélevé respectivement sur une sortie d'une porte OU-EXCLUSIF, une première entrée d'une porte OU-EXCLUSIF (XOR1) pour le quatrième élément (E4) du vecteur de résultat étant reliée à la première sortie du second circuit logique, tandis qu'une seconde sortie de cette même porte OU-EXCLUSIF (XOR1) est reliée à la première sortie du quatrième circuit logique, et qu'une première entrée de l'autre porte OU-EXCLUSIF (XOR2) pour le cinquième élément (E5) du vecteur de résultat est reliée à la première sortie du troisième circuit logique, tandis qu'une seconde entrée de cette même porte OU-EXCLUSIF (XOR2) est reliée à la première sortie du quatrième circuit logique.

10. Dispositif suivant la revendication 9, caractérisé par le fait qu'un circuit logique contient quatre portes OU-EXCLUSIF (XOR3, XOR4, XOR5, XOR6), une première porte OU-EXCLUSIF (XOR3) d'un circuit logique comportant des première et seconde entrées représentant respectivement les première et seconde entrées d'un circuit logique, tandis qu'une seconde porte OU-EXCLUSIF (XOR4) d'un circuit logique comportant des première et seconde entrées représente respectivement les troisième et quatrième entrées d'un circuit logique, qu'une troisième porte OU-EXCLUSIF (XOR5) est reliée à la seconde entrée des première et seconde portes OU-EXCLUSIF (XOR3, XOR4) d'un circuit logique, que respectivement une sortie des première et seconde portes OU-EXCLUSIF (XOR3, XOR4) d'un circuit logique sont raccordées à une entrée d'une quatrième porte OU-EXCLUSIF (XOR6) d'un circuit logique et qu'une sortie de cette quatrième porte OU-EXCLUSIF (XOR6) forme la première sortie d'un circuit logique, qu'une sortie de la troisième porte OU-EXCLUSIF (XOR5) d'un circuit logique représente la seconde sortie d'un circuit logique et qu'une sortie de la seconde porte OU-EXCLUSIF (XOR4) d'un circuit logique représente la troisième sortie d'un circuit logique.

11. Dispositif suivant l'une des revendications 8 à 10, caractérisé par le fait que l'autre porte OU-EXCLUSIF (XOR2) pour le cinquième élément (E5) du vecteur de résultat fait partie du cinquième module de contrôle de parité (PM5) du premier circuit de contrôle de parité.

12. Dispositif suivant l'une des revendications 6 à 11, caractérisé par le fait que les modules de contrôle de parité sont constitués respectivement de première, seconde et troisième portes OU-EXCLUSIF, les portes OU-EXCLUSIF ayant deux entrées et une sortie et la sortie de la première porte OU-EXCLUSIF (XOR1') étant raccordée à une première entrée de la troisième porte OU-EXCLUSIF (XOR3'), tandis que la sortie de la seconde porte OU-EXCLUSIF (OXOR2) est raccordée à une seconde entrée de la troisième porte OU-EXCLUSIF (XOR3'), que des première et seconde entrées (E1, E2) de la première porte OU-EXCLUSIF (XOR1') et des première et seconde entrées (E3, E4) de la seconde porte OU-EXCLUSIF constituent les entrées du module de contrôle de parité, tandis qu'une sortie de la troisième porte OU-EXCLUSIF (XOR3') constitue la sortie (A) de ce module de contrôle de parité.

13. Dispositif suivant l'une des revendications 6 à 11, caractérisé par le fait que les modules de contrôle de parité sont constitués respectivement par quatre étages push-pull chaînés et que deux étages push-pull chaînés y forment une fonction OU-EXCLUSIF, chaque étage push-pull comportant des première et se-

20

conde entrées de tension, des première et seconde sorties de tension et des première et seconde entrées de données, et la première entrée de tension du premier étage push-pull est raccordée à une première tension ($V_{DD}$) tandis que la seconde entrée de tension du premier étage push-pull est raccordée à une seconde tension ($V_{SS}$), que les première et seconde sorties de tension du quatrième étage push-pull forment des première et seconde sorties complémentaires du module de contrôle de parité (OUT, OUTQ), que les étages push-pull sont chaînés de sorte que respectivement des première et seconde sorties de tension d'un étage push-pull sont raccordées respectivement à des première et seconde entrées de tension de l'autre étage push-pull, et que respectivement les première et seconde entrées de données complémentaires (IN1,IN2,IN3,IN4; INQ1,INQ2,INQ3, INQ4) des quatre étages push-pull représentent des entrées du module de contrôle de parité.

14. Dispositif suivant la revendication 13, caractérisé par le fait qu'un étage push-pull est constitué de quatre transistors à effet de champ du même type de conduction, parmi lesquels des premier et second transistors à effet de champ (T1,T2) forment un premier circuit série et des troisième et quatrième transistors à effet de champ (T3,T4) forment un second circuit série, que les premier et second circuits série sont branchés en parallèle, une borne du premier transistor à effet de champ (T1) et une borne du quatrième transistor à effet de champ (T4) constituent une première borne commune, tandis qu'une borne du second transistor à effet de champ (T2) et une borne du troisième transistor à effet de champ (T3) forment une seconde borne commune, que la première borne commune forme une première entrée de tension et que la seconde borne commune forme une seconde entrée de tension, qu'une borne médiane du premier circuit série représente une première sortie de tension et qu'une borne médiane du second circuit série forme une seconde sortie de tension d'un étage push-pull, qu'une borne de grille du premier transistor à effet de champ (T1) et une borne de grille du troisième transistor à effet de champ (T3) forment en commun une première entrée de données (IN1) et qu'une borne de grille du second transistor à effet de champ (T2) et une borne de grille du quatrième transistor à effet de champ (T4) forment en commun une seconde entrée de données (INQ1).

15. Dispositif suivant la revendication 14, caractérisé par le fait que les transistors à effet de champ des étages push-pull sont des transistors à effet de champ à canal n et que la valeur de tension fixe est formée par le potentiel de référence constitué par la masse.

16. Dispositif suivant la revendication 14, caractérisé par le fait que les transistors à effet de champ des étages push-pull sont des transistors à effet de champ à canal p et que la valeur de tension fixe est formée par la tension de service.

## FIG 1

## FIG 3

FIG 2

# FIG 4

# FIG 5

# FIG 6